# EUROPEAN PATENT APPLICATION

(11) **EP 2 221 670 A2**
(43) Date of publication of application: **25.08.2010**
(21) Application number: 10001893.6
(22) Date of filing: 24.02.2010
(51) Int. Cl.: G03F 7/30

(54) **Automatic developing apparatus and processing method for lithographic printing plate precursor**

(30) Priority: 24.02.2009 JP 2009041380
(71) Applicant: FUJIFILM Corporation, Tokyo (JP)
(72) Inventor: Yoshida, Susumu, Haibara-gun Shizuoka (JP); Ohishi, Chikashi, Haibara-gun Shizuoka (JP)
(74) Representative: HOFFMANN EITLE

(57) **Abstract**

An automatic developing apparatus for a lithographic printing plate precursor, in which a lithographic printing plate precursor including in the following order a support, an image-recording layer and a protective layer is immersed in a developer in a development processing bath after image exposure and heating of the lithographic printing plate precursor to remove the image-recording layer in a non-image area and the protective layer at the same time, includes an insertion roller for introducing the lithographic printing plate precursor into the developing processing bath, a submerged roller disposed in the developer and a guide roller which is arranged between the insertion roller and the submerged roller in the developer and supports the lithographic printing plate precursor transported.

## Description

### FIELD OF THE INVENTION

The present invention relates to an automatic developing apparatus and a processing method for a lithographic printing plate precursor.

### BACKGROUND OF THE INVENTION

In general, a lithographic printing plate is composed of an oleophilic image area accepting ink and a hydrophilic non-image area accepting dampening water in the process of printing. Lithographic printing is a printing method which comprises rendering the oleophilic image area of the lithographic printing plate to an ink-receptive area and the hydrophilic non-image area thereof to a dampening water-receptive area (ink unreceptive area), thereby making a difference in adherence of ink on the surface of the lithographic printing plate, and depositing the ink only on the image area by utilizing the nature of water and printing ink to repel with each other, and then transferring the ink to a printing material, for example, paper.

In order to prepare the lithographic printing plate, a lithographic printing plate precursor (PS plate) comprising a hydrophilic support having provided thereon an oleophilic photosensitive resin layer (also referred to as a photosensitive layer or an image-recording layer) has heretofore been broadly used. Ordinarily, the lithographic printing plate is obtained by conducting plate making according to a method of exposing the lithographic printing plate precursor through an original, for example, a lith film, and then removing the unnecessary non-image area of the image-recording layer other than the image area by dissolving with an alkaline developer or an organic solvent thereby revealing the hydrophilic surface of support while leaving the image-recording layer in the portion for forming the image area.

Thus, in the hitherto known plate making process of lithographic printing plate precursor, after exposure, the step of removing the unnecessary portion of the image-recording layer by dissolving, for example, with a developer is required. However, in view of the environment and safety, processing with a developer closer to a neutral range and reduction of an amount of waste liquid are problems to be solved. Particularly, since disposal of waste liquid discharged accompanying the wet treatment has become a great concern throughout the field of industry in view of the consideration for global environment in recent years, the demand for the resolution of the above-described problems has been increased more and more.

On the other hand, digitalized technique of electronically processing, accumulating and outputting image information using a computer has been popularized in recent years, and various new image outputting systems responding to the digitalized technique have been put into practical use. Correspondingly, attention has been drawn to a computer-to-plate (CTP) technique of carrying digitalized image information on highly converging radiation, for example, laser light and conducting scanning exposure of a lithographic printing plate precursor with the light thereby directly preparing a lithographic printing plate without using a lith film. Thus, it is one of the important technical subjects to obtain a lithographic printing plate precursor adaptable to the technique described above.

As described above, the decrease in alkali concentration of developer and the simplification of processing step have been further strongly required from both aspects of the consideration for global environment and the adaptation for space saving and low running cost.

However, as described above, the development processing ordinarily comprises six steps of heating an imagewise exposed lithographic printing plate precursor in a pre-heating unit, removing a protective layer in a pre-water washing unit for removing the protective layer, developing the lithographic printing plate precursor with an alkali developer having pH of 10 or more, removing the alkali agent in a water washing bath, treating the lithographic printing plate with a gum solution mainly comprising a hydrophilic resin and drying the surface of lithographic printing plate (see JP-A-2002-91016 (the term "JP-A" as used herein means an "unexamined published Japanese patent application")). Therefore, an automatic developing apparatus per se requires a large space and problems of the environment and running cost still remain, because the pre-water washing waste liquid, development waste liquid, water washing waste liquid and gum waste liquid are discharged.

Thus a constitutional example has been proposed in EP-A-1788442 wherein hitherto known development processing steps are simplified and comprises three steps of pre-heating, development and drying. The pre-heating in the three steps of pre-heating, development and drying is carried out in order to accelerate a curing reaction insufficient only by the exposure. It has the advantage that printing performance, for example, printing durability is improved.

Also, mono-bath processing with a processing solution having pH of 3 to 9 and containing a water-soluble polymer compound is described in JP-T-2007-538279 (the term "JP-T" as used herein means a published Japanese translation of a PCT patent application).

Further, development processing with a developer having pH of 8.5 to 11.5 and containing an alkali metal carbonate and an alkali metal hydrogen carbonate is described in JP-A-11-65126.

### SUMMARY OF THE INVENTION

By the way, when a lithographic printing plate precursor heated in a pre-heating unit is introduced into a developing tank of a developing unit while maintaining high temperature, a phenomenon occurs in that the lithographic printing plate precursor runs wild caused by the occurrence of wrinkle-like strains (so-called kinking) when the lithographic printing plate precursor is nipped with submerged rollers in the developing tank and as a result, a developer in a development processing bath spatters to adhere to an insertion roller disposed on an inlet side of the developing processing bath to tend to contaminate the insertion roller. In the hitherto known development processing steps, since the lithographic printing plate precursor pre-heated at around 100°C is cooled in a pre-water washing unit and then carried into the developing unit, such a problem does not occur. On the contrary, in the development processing process comprising three steps of pre-heating, development and drying, since the lithographic printing plate precursor is introduced into a developer around 28°C while maintaining the high temperature around 100°C, the phenomenon in that the lithographic printing plate precursor runs wild occurs. It has been found that the developer spattered adheres to the insertion roller to give rise to the contamination. Further, there is a problem in that accumulation of the contamination of insertion roller causes development defect because the accumulated contaminant on the insertion roller adheres onto the surface of lithographic printing plate precursor at the development processing.

An object of the present invention is to provide an automatic developing apparatus for a lithographic printing plate precursor and a processing method of a lithographic printing plate precursor each of which can prevent the contamination caused by the adhesion of developer onto the insertion roller for introducing the lithographic printing plate precursor into the developing unit and prepare a lithographic printing plate of high quality.

The inventor has found that when a guide roller for controlling behavior of the lithographic printing plate precursor is disposed in order to inhibit the phenomenon of running wild of the lithographic printing plate precursor transported in the developer in the developing unit, the adhesion of spattered developer to the insertion roller disposed on the inlet side of developing unit can be effectively prevented.

Specifically, the automatic developing apparatus for a lithographic printing plate precursor according to the present invention is an automatic developing apparatus for a lithographic printing plate precursor in which a lithographic printing plate precursor comprising a support, an image-recording layer and a protective layer in this order is immersed in a developer of a development processing bath after image exposure and heating of the lithographic printing plate precursor to remove the image-recording layer in the non-image area and the protective layer at the same time and which is provided with an insertion roller for introducing the lithographic printing plate precursor into the developing processing bath, a submerged roller disposed in the developer and a guide roller which is arranged between the insertion roller and the submerged roller in the developer and supports the lithographic printing plate precursor transported.

The processing method of a lithographic printing plate precursor according to the present invention is a processing method of a lithographic printing plate precursor in which a lithographic printing plate precursor comprising a support, an image-recording layer and a protective layer in this order is immersed in a developer of a development processing bath after image exposure and heating of the lithographic printing plate precursor to remove the image-recording layer in the non-image area and the protective layer at the same time and which comprises introducing the lithographic printing plate precursor into the development processing bath with an insertion roller, transporting the lithographic printing plate precursor in the developer through a submerged roller disposed in the developer and supporting the lithographic printing plate precursor transported with a guide roller arranged between the insertion roller and the submerged roller.

According to the invention, due to the installation of a guide roller on the inlet side of developing tank, when the lithographic printing plate precursor is transported in the developer, the behavior of lithographic printing plate precursor can be controlled by the guide roller to inhibit the running wild of the lithographic printing plate precursor. Thus, the spatter of developer caused by the running wild of the lithographic printing plate precursor can be prevented and the adhesion of spattered developer to the insertion roller disposed on the inlet side of developing unit can be prevented. As a result, the occurrence of contamination on the insertion roller can be inhibited to prepare a lithographic printing plate of high quality. Also, the guide roller makes possible smooth transportation of the lithographic printing plate precursor along the transporting pass in the developer. Therefore, according to the invention, a developing processing process of three-step processing configuration comprising pre-heating, development and drying can be adopted and the lithographic printing plate precursor heated in the pre-heating unit is directly transported into the developing unit.

It is preferred that a guide member is provided in the developer and the guide member has a surface facing the guide roller and capable of supporting the lithographic printing plate precursor.

This makes it possible to support the lithographic printing plate precursor so as to hold it between the guide roller and the guide member, whereby the lithographic printing plate precursor can be smoothly transported along the transporting pass in the developer.

The guide roller is preferably disposed so that D2/D1 satisfies from 0.25 to 0.75, wherein D1 represents a distance from an intersection point of liquid level of the developer in the development processing bath with the transporting pass of lithographic printing plate precursor to a point where the transporting pass comes into contact with the submerged roller and D2 represents a distance from the intersection point to a point where the transporting pass comes into contact with the guide roller.

When the guide roller is disposed at the position defined above, the control of the behavior of lithographic printing plate precursor is more steadily performed. Also, the occurrence of image unevenness in the lithographic printing plate precursor is more effectively prevented. The reason for this is that when the position of the guide roller is close to the insertion roller, dissolution of the uppermost layer, that is, the protective layer is inhibited to cause the unevenness and on the other hand, when the position of the guide roller is close to the submerged roller, dissolution of the image-recording layer is affected to be apt to cause the unevenness.

It is preferred that the guide roller comprises a shaft member capable of passing the developer through the inside thereof and plural roller members arranged at intervals in the shaft direction of the shaft member and the shaft member has an aperture for ejecting the developer.

In this way, the guide roller has both the function of supporting the lithographic printing plate precursor transported and the function of a spray pipe for the developer and increase in the design freedom, simplification and miniaturization of the automatic developing apparatus can be achieved.

It is preferred that a spatter-preventing member is disposed between the insertion roller and the development processing bath so as to project from the edge of development processing bath to the vicinity of transporting pass.

In this way, even if the developer spatters caused by the behavior of lithographic printing plate precursor, adhesion of the developer to the insertion roller is prevented by the spatter-preventing member. In order to prevent the adhesion of developer to the insertion roller, it may be proposed to design the wall of the development processing bath on the insertion roller side to be high. This requires, however, large curvature of the transporting pass of lithographic printing plate precursor in order to keep away from the wall to result in decrease in the transferability. In the construction provided with the spatter-preventing member, a film or the like can be appropriately selected as a material of the spatter-preventing member. When the spatter-preventing member is disposed so as to come into sliding contact with the lithographic printing plate precursor transported, the change in the transporting pass is unnecessary and the design freedom of the automatic developing apparatus increases.

It is preferred that a heating unit for heating the lithographic printing plate precursor after the image exposure at 80 to 140°C is disposed.

It is preferred that the developer contains at least one of a surfactant and a water-soluble polymer compound.

It is preferred that the developer has pH of 8.5 to 10.8.

It is preferred that the developer further contains a low molecular weight hydroxycarboxylate ion.

It is preferred that the removal of the non-image area of the image-recording layer and the protective layer and an oil-desensitizing treatment are performed at the same time.

It is preferred that the image-recording layer has a photopolymerizable property.

According to the present invention, an automatic developing apparatus for a lithographic printing plate precursor and a processing method of a lithographic printing plate precursor each of which can prevent the contamination caused by the adhesion of developer onto the insertion roller for introducing the lithographic printing plate precursor into the developing unit and prepare a lithographic printing plate of high quality can be provided.

### BRIEF DESCRIPTION OF THE DRAWINGS

Fig. 1 is a view showing a construction of an automatic developing apparatus for a lithographic printing plate precursor.
Fig. 2 is a cross-sectional view showing a construction of a lithographic printing plate precursor.
Fig. 3 is a view showing a partial construction of a developing unit.
Figs. 4A and 4B are views showing a construction of a guide roller and a guide member.
Fig. 5 is a view showing construction of a developing unit partially modified.
Figs. 6A, 6B and 6C are views showing position of a guide roller in each example.

### DETAILED DESCRIPTION OF THE INVENTION

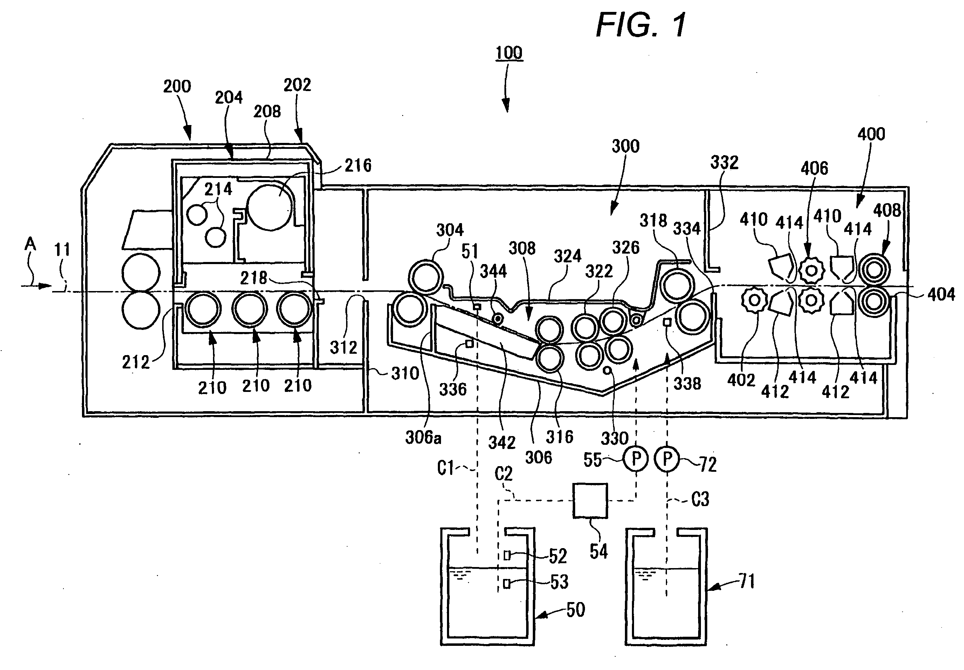

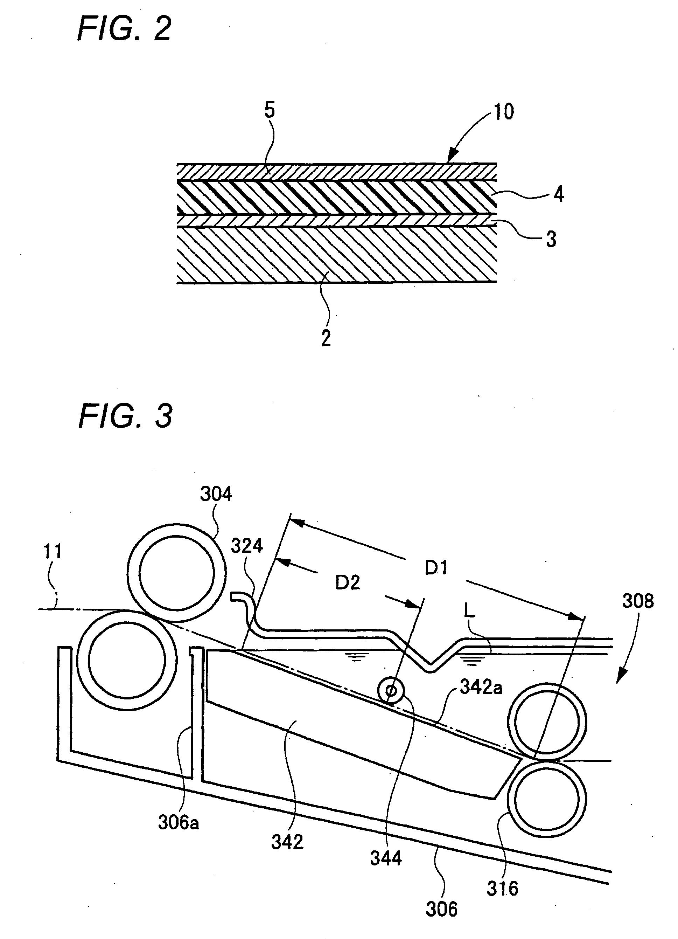

One embodiment of the invention will be described in detail below with reference to the drawings. Fig.1 is a constructive view of an automatic developing apparatus for explaining one embodiment of the invention. Fig. 2 is a cross-sectional view showing a construction of a photosensitive lithographic printing plate precursor.

The automatic developing apparatus is applied to development processing of a photosensitive lithographic printing plate precursor (hereinafter, also referred to as a PS plate) exposed imagewise by an exposure apparatus (not shown). As shown in Fig. 1, the automatic developing apparatus 100 comprises a pre-heating unit 200 for heating a PS plate 10, a developing unit 300 for performing development processing and gum treatment at the same time and a drying unit 400.

The PS plate 10 which is developed in the automatic developing apparatus 100 according to the present embodiment comprises an image-recording layer 4 having a photopolymerizable property provided on one surface of a support 2 of a thin plate using, for example, aluminum, through an adhesion layer 3 and a protective layer 5 provided on the image-recording layer 4 as shown in Fig. 2. In advance, the PS plate 10 is exposed imagewise by bringing an original film having an original image formed into close contact with the photosensitive side thereof or directly exposed by laser scanning exposure based on digital data. The PS plate 10 is introduced into the automatic developing apparatus 100 in the direction indicated by arrow A in Fig. 1. and transported in the automatic developing apparatus 100 along a transporting path 11 indicated by a dashed-dotted line in Fig. 1. Hereinafter, the side on which the PS plate 10 is introduced with respect to the transporting path is referred to as an upstream side and the opposite side is referred to as a downstream side.

In the pre-heating unit 200, the PS plate 10 is subjected to a pre-heat treatment prior to the development processing. The PS plate 10 subjected to the pre-heat treatment in the pre-heating unit 200 is subjected to the development processing in the developing unit 300.

In the pre-heating unit 200, a heating unit 204 is provided on the upstream side in the transporting direction of the PS plate 10 in a machine casing 202. In the heating unit 204, plural skewer rollers 210 are arranged along the transporting path 11 in a heating chamber 208. In the heating chamber 208, a heater 214 is provided on the side of an inlet 212 for carrying in the PS plate 10 and a circulation fan 216 is provided on the downstream side of the heater 214.

The heating unit 204 is constructed so as to keep the predefined temperature and predefined heating time when the PS plate 10 passes through the heating chamber 208, whereby the image-recording layer of the PS plate 10 is adequately cured to increase printing durability of the PS plate 10.

In the developing unit 300, a processing tank 306 is provided in which the PS plate 10 is transported to undergo development processing. In the processing tank 306, a developing tank 308 is formed which functions as a development processing bath for housing and holding a processing solution (hereinafter, also referred to as a developer) for performing development processing and oil-desensitizing treatment at the same time.

The developing tank 308 has a configuration of sagging downwards in the center of bottom so as to easily store the developer.

In an outer panel 310 surrounding the processing tank 306, an insertion slot 312 of slit type is formed on the upstream side of the processing tank 306.

In an insertion unit 302, a pair of insertion rollers 304 is disposed. The insertion roller is, for example, a solid roller having a surface made of rubber. The PS plate exposed imagewise by an exposure apparatus (not shown) and subjected to the pre-heat treatment in the heating unit 204 is transported along the direction indicated by arrow A through the insertion slot 312 and fed between a pair of insertion rollers 304.

The PS plate is introduced into a developer in the processing tank 306 along the transporting path 11 by rotary drive of the pair of insertion rollers 304.

On this occasion, it is preferable that the pair of insertion rollers 304 draws the PS plate 10 through the insertion slot 312 and feeds it into the developer at an angle ranging from about 15° to about 31° to the horizontal direction. In the developing unit 300 used for processing a PS plate 10 of single-side type, the PS plate 10 is introduced through the insertion slot 312 in a state where the image-recording layer faces upward. Specifically, the PS plate 10 is processed in the developing unit 300 in the state where the image-recording layer thereof faces upward.

In the developing tank 308, a pair of submerged rollers 316, a pair of brush rollers 322, a pair of brush rollers 326 and a pair of carrying-out rollers 318 are provided in order from the upstream side along the transporting path 11 of the PS plate 10. The pair of insertion rollers 304, pair of submerged rollers 316, pair of brush rollers 322, pair of brush rollers 326 and pair of carrying-out rollers 318 are placed adjacent to each other or at intervals across the transporting path 11 respectively to support the PS plate transported so as to hold it from both sides.

The pair of carrying-out rollers 318 transports the PS plate 10 to the drying unit 400 adjacent to the downstream side of the developing unit 300.

In the developing tank 308 of the developing unit 300, a guide member 342 is provided downward the transporting direction of the transporting path 11 between the pair of insertion rollers 304 and the pair of submerged rollers 316. Also, a guide roller 344 is disposed against the guide member 342 across the transporting path 11. Specific constructions of the guide member 342 and guide roller 344 are described hereinafter.

The pair of submerged rollers 316 guides the PS plate transported obliquely downward from the pair of insertion rollers 304 to the pair of brush rollers 322 in the bottom of the developing tank 308.

The pair of brush rollers 322 and the pair of brush rollers 326 are rotarily driven in the prescribed rotating direction and the prescribed rotating number and come into sliding contact with the surface of the PS plate 10 transported from the submerged rollers 316 to brush the surface of the PS plate 10. By the brushing with the pair of brush rollers 322 and the pair of brush rollers 326, the non-image area of the image-recording layer 4 and the protective layer 5 of the PS plate 10 are removed.

The pair of carrying-out rollers 318, which is constituted, for example, from rollers having rubber periphery, supports the PS plate 10 transported from the pair of brush rollers 326 to transport it from the developing tank 308 to the drying unit 400.

In the developing tank 308, a spray pipe 330 is provided under the brush roller 322 and the brush roller 326. Into the spray pipe 330, the developer in the developing tank 308 aspirated by a pump (not shown) is supplied and the developer is ejected from the spray pipe 330 in the developing tank 308. Thus, the developer in the developing tank 308 is stirred so that uniform processing of the PS plate 10 becomes possible.

A liquid temperature sensor 336 is provided on the downstream side of the pair of insertion rollers 304. The liquid temperature sensor 336 detects temperature of the developer in the vicinity of the area where the PS plate 10 subjected to the pre-heat treatment is introduced. The position in which the liquid temperature sensor 336 is located can be varied in the area where the temperature of developer is properly detected and is not particularly restricted.

Also, a liquid level meter 338 for detecting the liquid level of developer is provided on the upstream side of the pair of carrying-out rollers in the developing tank 308. The liquid level meter 338 contributes to prevent heating of the developing tank without the developer due to lack or depletion of the developer, to maintain constantly the liquid level of developer in the proper range and to stabilize the developing time. The position in which the liquid level meter 338 is located can be varied in the area where the liquid level of developer is properly detected and is not particularly restricted.

The PS plate 10 is fed into the drying unit 400 while squeezing the developer attached on the surfaces of PS plate by the pair of carrying-out rollers 318. The PS plate 10 subjected to the development processing and oil-desensitizing treatment in the developing unit 300 is fed into the drying unit 400 with some residual developer, specifically with a thin film of the developer (gum solution), on the front and rear surfaces thereof.

Between the developing unit and the drying unit, a partition board 332 is provided. The partition board 332 is located above the downstream side of the pair of carrying-out rollers 318 with respect to the transporting path 11. In the partition board 332, a pass-through slot 334 of slit type for passing the PS plate transported is formed. The partition board 332 may have dual structure. In this case, it is possible that a groove-like air passage is formed on the drying unit 400 side of the pass-through slot 334 and the air in the drying unit 400 is actively introduced into the pass-through slot to prevent the air in the drying unit 400 from entering the developing unit 300 through the pass-through slot 334.

A shielding cover 324 is located above the developing tank 308 so as to shield the developing tank 308. The shielding cover 324 prevents vaporization of water in the developer in the developing tank 308. A blade-like shielding member (not shown) formed, for example, by silicone rubber may be placed between the shielding cover 324 and the processing tank 306 or between the shielding cover 324 and the insertion roller 304 and carrying-out rollers 318. It is more preferable to do so because the vaporization of water in the developer due to contact of the developer in the developing tank 308 with outside air can be prevented.

Also, in the developing tank 308, a mechanism for replenishing water corresponding to the amount of evaporated water may be provided. The water replenishment is ordinarily carried out by a method of accumulative replenishment of water based on accumulation of outage time at the start or a method of replenishment at regular time intervals during operating time. The replenishment may be conducted in response to the detection by the liquid level meter 338. The water replenishment may also be conducted according to a method of ejecting water to a drive gear unit of a brush or roller. Since the developer component or photosensitive layer component is apt to adhere onto the drive gear unit in the mono-bath processing, the replenishing water is poured over the drive gear unit to constantly clean it.

Specific constructions of the guide member 342 and guide roller 344 are described below.

Fig. 3 is a view showing a partial construction of a developing unit. In Fig. 3, a part on the upstream side of the developing tank 308 is specifically shown. L in Fig. 3 indicates a liquid level L of the developer.

The guide member 342 is formed as an elongated member obliquely extended from neighborhood of an edge 306a on the side of insertion roller 304 of a wall separating a part housing the developer in the processing tank 306 to neighborhood of the upstream side of the submerged roller 316. The guide member 342 has a surface 342a nearly parallel to the transporting path 11 and is able to support the PS plate transported with the surface 342a. The PS plate 10 is transported along the transporting path 11 in the developer while one surface thereof is supported with the surface 342a of the guide member 342. In this case, another surface of the PS plate 10 which is supported with the guide member 342 is supported with the guide roller 344.

Due to the installation of the guide roller 344 in the developing tank 308, when the PS plate 10 is transported in the developer, the behavior of PS plate 10 can be controlled by the guide roller to inhibit the running wild of the PS plate. Thus, the spatter of developer caused by the running wild of the PS plate can be prevented and the adhesion of spattered developer to the insertion roller 304 disposed on the inlet side of the developing unit 300 can be prevented. As a result, the occurrence of contamination on the insertion roller 304 can be inhibited to prepare a lithographic printing plate of high quality. Also, the guide roller 344 makes possible smooth transportation of the PS plate along the transporting pass 11 in the developer. Therefore, a developing processing process of three-step processing configuration comprising pre-heating, development and drying can be adopted and the PS plate heated in the pre-heating unit 200 is directly transported into the developing unit 300 as described in the automatic developing apparatus 100 shown in Fig. 1.

As shown in Fig. 3, the guide roller 344 is disposed so that D2/D1 satisfies from 0.25 to 0.75, wherein D1 represents a distance from an intersection point of liquid level of the developer in the development processing bath with the transporting pass 11 of PS plate to a point where the transporting pass 11 comes into contact with the submerged roller 316 and D2 represents a distance from the intersection point to a point where the transporting pass 11 comes into contact with the guide roller 344.

When the guide roller 344 is disposed at the position defined above, the control of the behavior of PS plate is more steadily performed. Also, the occurrence of image unevenness in the PS plate is more effectively prevented. The reason for this is that when the position of the guide roller 344 is close to the insertion roller 304, dissolution of the uppermost layer, that is, the protective layer 5 is inhibited to cause the unevenness and on the other hand, when the position of the guide roller is close to the submerged roller 316, dissolution of the image-recording layer 4 is affected to be apt to cause a so-called image unevenness, although the position of the guide roller 344 has a small effect in view of the prevention of the adhesion of developer to the insertion roller 304.

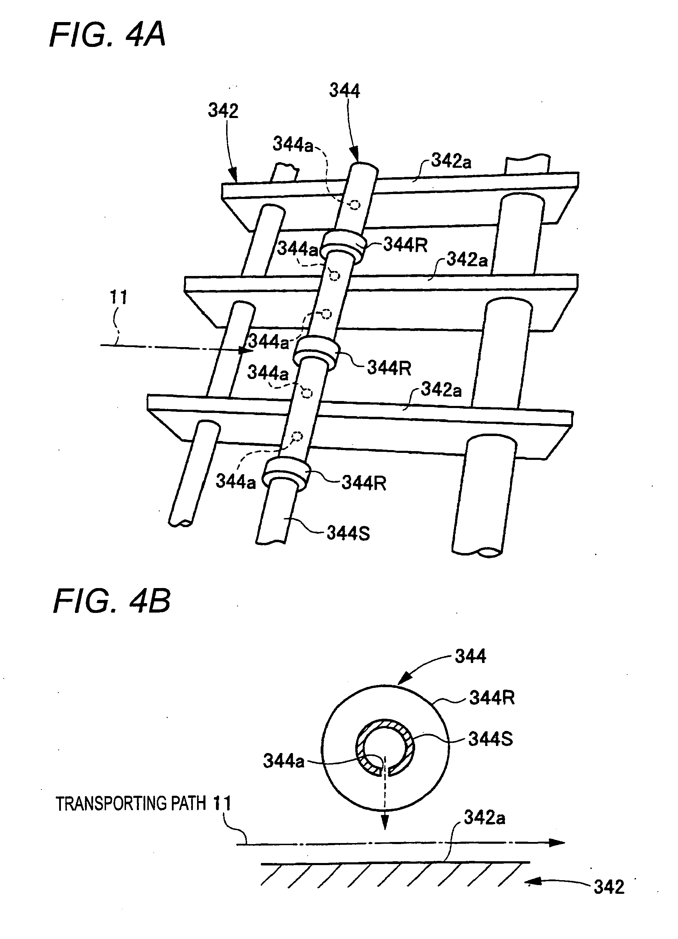

Figs. 4A and 4B are views showing a construction of the guide member and guide roller. Fig. 4A shows a positional relation between the guide member and the guide roller and Fig. 4B shows a cross-section parallel to the transporting path in Fig. 4A.

The guide member 342 is constructed from plural elongated members having a surface 342a for supporting the PS plate 10 which are disposed parallel to the direction of the transporting pass 11 and connected each other at intervals in a vertical direction to the direction of the transporting pass 11. When the PS plate 10 is transported between each surface 342a of plural guide members 342 and the guide roller 344, the developer moved by pressing with the PS plate actively runs in the clearances between the elongated members constructing the guide member 342 so that the spatter of developer outside of the processing tank 306 can be prevented.

The guide roller 344 comprises a shaft member 344S constructed, for example, by a hollow stainless and plural roller members 344R arranged at intervals in the shaft direction of the shaft member 334S. The guide roller 344 is not restricted to a so-called skewer roller as described above but may be a so-called solid roller in which the shaft direction of the shaft member 334S is totally used the roller member.

According to the construction, the shaft member 344S of the guide roller 344 is able to pass the developer through the inside thereof. In this way, since the guide roller 344 has the function of supporting the PS plate transported and the function of a spray pipe for ejecting the developer, the design freedom of the automatic developing apparatus increases and simplification and miniaturization of the automatic developing apparatus can be achieved.

As shown in Fig. 1, in the drying unit 400, a support roller 402 for supporting the PS plate 10 is disposed near the pass-through slot 334 and a transport roller pair 406 and a transport roller pair 408 are disposed in the center portion of the transporting direction of PS plate 10 and near a discharge slot 404, respectively. The PS plate 10 is transported in the drying unit 400 by the support roller 402 and the transport roller pairs 406 and 408.

Between the support roller 402 and the transport roller pair 406 and between the transport roller pair 406 and the transport roller pair 408, ducts 410 and 412 are provided to form pairs across the transporting pass 11 of PS plate 10, respectively. The ducts 410 and 412 are disposed so that the lengthwise directions thereof follow the width direction of PS plate 10 and each has a slit hole 414 for blasting dry air on the surface facing the transporting pass 11 of PS plate 10.

When dry air generated by a dry air generating means (not shown) is supplied from one end in the lengthwise direction of each of the ducts 410 and 412, the duct blasts the dry air from the slit hole 414 to the transporting pass 11 of PS plate 10 to blast the PS plate 10. In this way, the coatings of developer (gum solution) formed on the front and rear surfaces of PS plate 10 are dried to form a protection film.

In the developing tank 308, an overflow aperture 51 which allows the developer to flow in is provided at a position substantially same as the liquid level of the developing tank 308. The automatic developing apparatus 100 may be separately provided with a first circulation pipeline C1 connecting to the overflow aperture 51, an external tank 50 which is capable of housing the developer and connected to the first circulation pipeline C1, a second circulation pipeline C2 for circulating the developer housing in the external tank 50 into developing tank 308, a supply pump 55 for circulating the developer along the second circulation pipeline C2, and a filter unit 54 for collecting aggregates contained in the circulating developer. The supply pump 55 may have construction in which it is controlled by a control device provided with control ROM and RAM with memory of developer replenishment conditions and the like inputted therein and a timekeeping unit, based on a plate detection sensor (not shown) and a timekeeping unit.

Further, the developer may be constantly circulated between the external tank 50 and the developing tank 308. For example, the developer may be constantly circulated in an amount of 100 to 1,000 ml/minute.

In order to replenish the decrease of water contained in the developing bath 308 due to vaporization, a water tank 71 for replenishment may be provided. The water pooled in the water tank 71 was supplied to the developing bath 308 through a replenishment pipeline C3 and a water-replenishing pump 72. The replenishment of water may be carried out in operation or in abeyance.

As the water for replenishment, water from which a so-called hard water component, for example, calcium or magnesium is eliminated by a water softening apparatus is preferable. As the water softening apparatus, a water softening apparatus of ion exchange resin type or a water softening apparatus of reverse osmosis membrane type can be used. As the water softening apparatus, Softener D'acqua M (trade name in Japan) produced by Inoxdep (agency: Komichi-Shobo Publishers), which is a water softening apparatus of ion exchange resin type, is preferable in view of performance, price and maintenance ability.

In the external tank 50, an upper limit liquid level meter 52 and a lower limit liquid level meter 53 are provided. The upper limit liquid level meter 52 detects the upper limit position of liquid level in order to prevent overflow of the developer held in the external tank 50. The lower limit liquid level meter 53 may also be used for correction of water vaporization same as the liquid level meter disposed in the developing tank 308. In order to prevent lack or depletion of the developer held in the developing tank 308 and the external tank 50 due to vaporization or the like, water can be newly replenished from the water tank 71 when the liquid level is undetectable at the detection of the lower level of the developer. The water replenishment may be performed to the developing tank 308 or directly to the external tank 50. An opportunity of the water replenishment is preferably at the time when the developer is circulated between the external tank 50 and the developing tank 308.

For the filter unit 54 placed in the second circulation pipeline C2, any type of filter, for example, membrane type, depth type, adsorption type, bag type or surface type can be used. A spool-shaped depth type filter is preferable because of cheapness and good versatility. Any material of the filter which is not corroded by the developer may be used and polypropylene, polyester, polyethylene or cotton is preferable.

Filtration accuracy of the filter unit 54 is usably from 0.5 to 250 µm, preferably from 5 to 150 µm, and more preferably from 10 to 100 µm. The reason for this is that when it is too fine, exchange frequency of the filter increases to lead the increase in cost. When it is too coarse, the scum is not collected to cause scum on the printing plate. Also, only a mesh filter may be used for protecting the pump. A mesh size is ordinarily from 10 to 1, 000 µm, and preferably from 20 to 700 µm.

The filter unit 54 may be provided only one or two or more. It is preferred to filtrate first by a coarse filter and then by a fine filter.

Further, a flowmeter (not shown) may be provided in the second circulation pipeline C2 so as to inform time for replacement of the filter unit 54 to the user.

As shown in the automatic developing apparatus 100, after conducting processing with only one bath of the developing tank 308, the PS plate 10 subjected to the development and oil-desensitizing treatment at the same time in the one bath is dried in the drying unit 400 provided subsequently. The completion of processing only one bath of the developing tank 308 makes it possible to save space as well as reduction in the cost of the apparatus. In addition, since the developer is circulated using the external tank 50, the liquid level of developer can be constantly maintained at a certain level so that the development processing is stabilized.

Moreover, a conventional apparatus has a construction in which even a developer still having developing ability is partially discarded as waste liquid. On the contrary, according to the automatic developing apparatus 100, due to the circulation of developer the developing ability of developer can be 100% utilized so that lifetime of the developer can be controlled. In addition, the height of liquid level can be easily controlled by the overflow.

Furthermore, since the developer contains a water-soluble resin, components of existing automatic developing apparatus are effectually utilized so that the large effect can be obtained by a small modification.

According to the automatic developing apparatus 100, since the PS plate 10 subjected to the development and oil-desensitizing treatment at the same time in the developing tank 308 is dried in the drying unit 400, when the processing is completed, as well as reduction in the cost of the apparatus, it is possible to save space. Further, since the development and rubbing treatment are conducted in the developer, scatter of the developer by spatter is prevented so that the problem in that the developer spattered is dried to form scum is solved. Moreover, since the developer is circulated, the liquid level of developer can be constantly maintained at a certain level so that the development processing is stabilized.

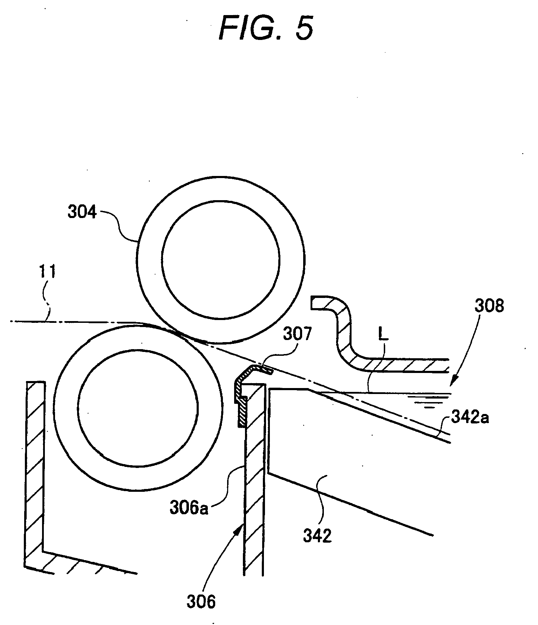

The constitution of the automatic developing apparatus 100 should not be construed as being limited to that described above and it can be appropriately modified. Fig. 5 is a view showing a modified embodiment in which the construction of developing tank is partially modified. In the developing tank 308, a spatter-preventing member 307 is disposed at an edge 306a of the processing tank 306 holding the developer. The spatter-preventing member 307 is placed between the insertion roller 304 and the processing tank 306 and even when the developer in the processing tank 306 spatters, it prevents the developer from adhering to the insertion roller 304. The spatter-preventing member 307 is fixed on the edge 306a at one end and an opposite end has a shape curved to the transporting direction of transporting path 11. The opposite end also has repulsive force based on elastic deformation and due to the repulsive force at least a part thereof comes into sliding contact with one surface (downside surface in Fig. 5) of the PS plate transported along the transporting path 11.

As the spatter-preventing member 307, a film-like or a blade-like member which has a small thickness (dimension to the direction of the transporting path 11) and flexibility and places a small burden when it comes into sliding contact with the PS plate transported is preferable.

The installation of spatter-preventing member 307 can prevent the developer from adhering to the insertion roller 304 even when the developer spatters caused by the behavior of PS plate. In order to prevent the adhesion of developer to the insertion roller 304, it may be proposed to design the wall of the processing tank 306 on the insertion roller 304 side to be high. This requires, however, large curvature of the transporting pass 11 of PS plate in order to keep away from the wall to result in decrease in the transferability. In the construction provided with the spatter-preventing member 307, when the spatter-preventing member is disposed so as to come into sliding contact with the PS plate, the change in the transporting pass 11 is unnecessary and the design freedom of the automatic developing apparatus 100 increases.

Now, the procedure for conducting the development processing of the PS plate 10 using the automatic developing apparatus 100 is described below.

Prior to the development processing by the automatic developing apparatus 100, the PS plate 10 is subjected to image exposure process by an exposure apparatus (not shown). In the exposure process by an exposure apparatus, the PS plate 10 is exposed through a transparent original having a line image, a halftone dot image or the like or exposed imagewise by scanning of laser beam based on digital data. Examples of light source preferably used for the exposure include a carbon arc lamp, a mercury lamp, a xenon lamp, a metal halide lamp, a strobo, an ultraviolet ray, an infrared ray and a laser beam. The laser beam is particularly preferable and includes, for example, a solid laser or a semiconductor laser emitting an infrared ray of 760 to 1,200 nm, an ultraviolet semiconductor laser emitting light of 250 to 420 nm, an argon ion laser or an FD-YAG laser, emitting visible light. Among them, the laser emitting an infrared ray or an ultraviolet ray is preferable in view of simplification of the plate making. The wavelength of ultraviolet exposure light source is preferably from 350 to 450 nm.

As for the available laser light source emitting light having a wavelength of 350 to 450 nm, the followings can be used. A gas laser, for example, Ar ion laser (364 nm, 351 nm, 10 mW to 1 W), Kr ion laser (356 nm, 351 nm, 10 mW to 1 W) and He-Cd laser (441 nm, 325 nm, 1 mW to 100 mW); a solid laser, for example, a combination of Nd:YAG (YVO₄) with SHG crystalsxtwice (355 nm, 5 mW to 1 W) and a combination of Cr:LiSAF with SHG crystal (430 nm, 10 mW); a semiconductor laser system, for example, a KNbO₃ ring resonator (430 nm, 30 mW) , a combination of a waveguide-type wavelength conversion element with an AlGaAs or InGaAs semiconductor (380 nm to 450 nm, 5 mW to 100 mW), a combination of a waveguide-type wavelength conversion element with an AlGaInP or AlGaAs semiconductor (300 nm to 350 nm, 5 mW to 100 mW), and AlGaInN (350 nm to 450 nm, 5 mW to 30 mW); a pulse laser, for example, N₂ laser (337 nm, pulse 0.1 to 10 mJ) and XeF (351 nm, pulse 10 to 250 mJ) can be used. Among the light sources, the AlGaInN semiconductor laser (commercially available InGaN semiconductor laser, 400 to 410 nm, 5 to 30 mW) is particularly preferable in view of the wavelength characteristics and cost.

As for the exposure apparatus for the lithographic printing plate precursor of scanning exposure system, the exposure mechanism may be any of an internal drum system, an external drum system and a flat bed system. As the light source, among the light sources described above, those capable of conducting continuous oscillation can be preferably utilized.

The PS plate 10 inserted through the insertion slot is introduced into the machine casing 202 and fed in the heating chamber 208. The PS plate 10 fed in the heating chamber 208 is transported while being heated by the heater 214, whereby the PS plate 10 is heated at the preset heating temperature and heating period. In this way, in the PS plate 10, polymerization degree of photopolymerizable compound contained in the image-recording layer 4 is enhanced to increase printing durability.

The PS plate 10 is fed from the pre-heating unit 200 to the developing unit 300 by nipping an end thereof discharged from the outlet 218 of heating chamber 208 by the insertion rollers 304 of developing unit 300. The PS plate 10 inserted through the insertion slot 312 is nipped by the insertion rollers 304 according to the rotary drive thereof to be introduced into the developing unit 300.

The PS plate 10 is then fed into the developer in the developing tank 308 and transported through the submerged rollers 316, the brush rollers 322, the brush rollers 326 and the carrying-out rollers 318 in order along the transporting path 11 in the developing tank 308 while being supported by the guide roller 344 in the developer.

The PS plate 10 is immersed in the developer in the developing tank 308 and the unnecessary image-recording layer 4 in the non-image area and the protective layer 5 are removed from the support 2. In the developing unit 300, then the surface (surface on the image-recording layer 4 side) of the PS plate is brushed with the brush rollers 322 and 326 disposed in the developing tank 308 to accelerate the removal of the unnecessary image-recording layer 4 from the surface of PS plate 10. By the immersion in the processing solution (developer), a gum component included in the processing solution is uniformly coated on the front and rear surfaces of the PS plate 10 simultaneously with the development processing. The rubbing treatment by the brush rollers 322 and 326 in the developing unit 300 is more effective in the case where the PS plate immersed in the developer is subjected to the rubbing treatment after the lapse of some period.

The PS plate 10 is carried away from the developer at a discharge angle ranging from 7° to 31° to the horizontal direction by the carrying-out rollers 318 of the developing tank 308. The PS plate carried away from the developing tank 308 is fed into the drying unit 400 by the carrying-out rollers 318. The carrying-out rollers 318 also function as squeezing rollers to squeeze out the developer (processing solution) attached on the PS plate 10 from the front and rear surfaces of the PS plate 10 thereby forming a uniform thin layer of the gum component on the front and rear surfaces of the PS plate 10.

The PS plate 10 is fed into the drying unit 400 through the pass-through slot 334 between the drying unit 300 and the drying unit 400. The pass-through slot 334 may be provided with a shutter. Thus, the shutter is activated in the timing of initiation of processing of the PS plate 10 or in the timing of carrying-out of the PS plate 10 from the developing unit 300 to open the pass-through slot 334. In this way, unnecessary entrance of dry air from the drying unit 400 to the developing unit 300 at the time when the PS plate 10 is not transported to cause adhesion of the gum component on the carrying-out rollers 318 can be prevented and also vaporization of water in the developer caused by the air entered through the pass-through slot 334 and discharge of the vapor from the pass-through slot 334 can be prevented. Also, the carrying-out rollers 318 may be intermittently activated during stoppage of the operation. During the standby operation, the carrying-out rollers 318 and the brush rollers 332 and 326 may be revolved for about one minute at intervals of 20 minutes. The setting time can be appropriately changed. Further, at the start of operation, the transporting rollers may be revolved for about 5 to 60 minutes to remove the developer component adhered.

In the drying unit 400, while the PS plate 10 is transported by the support roller 402 and the transport roller pairs 406 and 408, dry air is blasted on the front and rear surfaces of plate 10 from the ducts 410 and 412. Thus, protective films are formed from the gum component coated on the surfaces of PS plate 10 and the PS plate is discharged through the discharge slot 404.

In the development processing using the automatic developing apparatus 100, first the developer penetrates into the image-recording layer 4 of PS plate 10 and then removal of the image-recording layer 4 in the non-image area is simply conducted. Therefore, immersion of the PS plate in the developer prior to initiation of the rubbing operation makes removal of the image-recording layer 4 more effective. According to the experiments, the elapsed time is preferably 2 seconds or more, more preferably 5 seconds or more, and still preferably 10 seconds or more. Since the development processing is ordinarily performed within 60 seconds, the elapsed time is inevitably shorter than 50 seconds.

Prior to the immersion into the developer, the image-recording layer 4 of PS plate 10 may come into contact with the developer using, for example, a spray tube (not shown). In this case, since a period of time from the contact of the image-recording layer 4 with the developer to carrying out of the rubbing operation in the developer is extended, the development can be more effectively conducted. Further, by the prior contact with the developer, a period of time from the immersion into the developer to carrying out of the rubbing operation can be appropriately reduced. In order to accelerate penetration of the developer, a method wherein the PS plate 10 is vibrated under the condition of contacting the PS plate with the developer can be appropriately used.

When the period of time from the immersion of the PS plate 10 into the developer to the leaving of the PS plate from the developer is taken as t seconds, the rubbing treatment by the brush rollers 322 and 326 is desirably performed t/2 seconds or longer after the immersion of the PS plate into the developer. Specifically, the rubbing treatment (development) is preferably conducted in the middle or latter part of the developing tank 308. Needless to say, it is possible to conduct the rubbing treatment in the former part of the developing tank 308 if the period for immersion in the developer is extended by making the developing tank 308 longer or decreasing the transportation speed of the PS plate. However, in order to perform constantly the stable development processing, the rubbing treatment by the brush rollers 322 and 326 is preferably performed in the middle or latter part of the developing tank 308.

The brush rollers 322 and 326 may be any member capable of rubbing the image-recording surface of the PS plate 10. In particular, a member capable of rotating around its rotation axis as the center thereof to rub the surface on the image-recording layer side (for example, a known channel brush, twisted brush, planted brush, carpet brush or Moulton roller) is preferably used.

As the channel brush, brushes produced by spirally winding a long so-called channel brush (strip brush) around a surface of a roller body as described in JP-UM-A-62-167253 (the term "JP-UM-A" as used herein means an "unexamined Japanese published utility model application"), JP-UM-A-4-63447, JP-UM-A-4-64128 and JP-A-6-186751 are used.

As the twisted brush, brushes produced by inserting a twisted brush into a spiral groove formed on the surface of a shaft thereby spirally winding it around the shaft as described in JP-A-3-87832 are used.

As the planted brush, brushes produced according to a method of planting a brush material in small holes formed in a shaft roller are used.

As the carpet brush, brushes produced by winding a long and thin strip of textile woven with wool material around a peripheral surface of a shaft roller as described in JP-A-2001-5193 and JP-A-2001-66788 are used.

As the Moulton roller, brushes produced by covering a roller body with a sliding sleeve of a woven fibrous material and firmly tightening the sleeve on the mounted side thereof as described in JP-A-10-198044 are used.

The number of revolution of the brush roller is preferably as large as possible for improving the removability of the image-recording layer in the unexposed area of the PS plate 10. However, from the standpoint of the durability and the production cost of the automatic developing apparatus 100 and of prevention of scattering of the developer and damage of the exposed area of the PS plate 10, it is preferably from 30 to 1,000 rpm, and more preferably from 50 to 500 rpm.

A number of the brush roller is at least one and plural brush rollers may also be used. In case where 2 or more brush rollers are used, at least one of them may be rotated in the direction opposite to the processing direction of the PS plate 10. Further, the development processing may be performed while the brush roller is rocked in the rotary axis direction. By rocking the brush roller in the rotary axis direction, the removal of non-image area of the PS plate 10 can be more effectively conducted and a lithographic printing plate having better quality can be prepared.

As a material of the brush for the brush roller, natural fibers, for example, horsehair or pig hair, artificial fibers, metal fibers and the like are known. In view of the chemical resistance thereof, artificial fibers are preferable. Examples of the artificial fiber usable include polyamides, for example, nylon 6, nylon 6. 6, nylon 6.10, nylon 6.12 or nylon 12, polyesters, for example, polyethylene terephthalate or polybutylene terephthalate (PBT), polyacrylics, for example, polyacrylonitrile or alkyl poly(meth)acrylate, polyolefins, for example, polyethylene, polypropylene, polystyrene, polyvinyl chloride or polyvinylidene chloride, celluloses, for example, acetyl cellulose, polyurethanes, for example, polyurethane, polyphenylene sulfide and fluorine resins, for example, ethylene/tetrafluoroethylene copolymer or polyvinylidene fluoride. In consideration of the elasticity, rigidity, abrasion resistance, heat resistance, chemical resistance, water absorbability and hygroscopic property thereof, nylon 6, nylon 6.6, nylon 6.10, nylon 6.12, nylon 12, polypropylene, polybutylene terephthalate and polyethylene terephthalate are preferable and nylon 6.6, nylon 6.10, nylon 6.12, nylon 12, polybutylene terephthalate (PBT) and polypropylene are more preferable. Of the polyesters, polybutylene terephthalate (PBT) is particularly preferable. Of the polyolefins, polypropylene is particularly preferable.

A width of the bristle of the brush is not particularly restricted and is preferably from 0.01 to 1.0 mm, and more preferably from 0.05 to 0.5 mm. When the width of the bristle of the brush is less than 0.01 mm, the rubbing property may become poor and when it is more than 1.0 mm, rubbing scratches may be formed on the surface of the plate. A length of the bristle of the brush is also not particularly restricted and is ordinarily in a range of 3 to 50 mm. When the length is shorter than 3 mm, the touch of the brush to the PS plate 10 may become uneven and the brush may often give rubbing scratches to the surface of the plate. When it is longer than 50 mm, it does not give any more advantage of development processing and it is economically disadvantageous. In case of the Moulton roller, since it has a sliding sleeve of a woven material, it is not necessary to define the width and the length of the bristle thereof.

According to the automatic developing apparatus 100, since the PS plate 10 is subjected to the oil-desensitizing treatment simultaneously with the development in the developing tank 308 and dried in the drying unit 400, it is possible to save space as well as reduction in the cost of the apparatus. Also, since the pre-heating unit 200 is provided, it is possible to prepare a lithographic printing plate excellent in printing durability.

Temperature of developer in ordinary development processing is in a range from 20 to 40°C, and preferably from 25 to 35°C. In case of exceeding the temperature range, when the temperature is 5°C higher, printing durability of the printing plate obtained is reduced and when it is 2°C higher, reduction in the thickness of image-recording layer arises. On the other hand, when the temperature is 2°C lower, due to insufficient development, remaining layer on the printing plate partially occurs and when it is 5°C lower, the remaining layer thoroughly occurs. As described above, the change in the developer temperature of only a few degrees has a large influence on the development result.

In ordinary development processing of lithographic printing plate precursor, since pH of developer is 12 or higher, the pH of developer is severely decreases due to carbon dioxide present in air and degradation of the developer rapidly proceeds when the developer is allowed to stand. On the contrary, in the processing method of lithographic printing plate precursor according to the invention, since pH of the developer can be adjusted in a range of 8.5 to 10.8, the decrease in pH due to carbon dioxide is inhibited. Thus, the lifetime of developer can be prolonged. When the developing property of lithographic printing plate precursor decreases by adjusting the pH of developer in the range of 8.5 to 10.8, it is preferred to control an amount of the surfactant added in a range of 1 to 30% by weight in order to improve the developing property. In this way, the decrease in developing property resulting from the decrease in pH is complemented so that the developing property can be well maintained.

### [Method of preparing lithographic printing plate]

Now, a method of preparing a lithographic printing plate using the PS plate is described in detail below. The method of preparing a lithographic printing plate comprises after image exposure (exposure step) of the PS plate, processing (developing step) with an aqueous solution containing at least one of a water-soluble polymer compound and a surfactant, and if desired, a low molecular weight hydroxycarboxylate ion. After the developing step, a water washing step and a finishing step may be provide.

The developing step is described in detail below. A conventional processing process comprises removing a protective layer in a pre-water washing step, conducting alkali development, removing the alkali in a post-water washing step, conducting gum treatment in a gumming step and drying in a drying step. On the contrary, the processing process according to the invention is characterized by conducting the development and gumming at the same time using an aqueous solution containing at least one of a water-soluble polymer compound and a surfactant. Thus, the post-water washing step is not particularly necessary, and after conducting the development and gumming with one solution, the drying step can be performed. Moreover, since the removal of protective layer can also be conducted simultaneously with the development and gumming, the pre-water washing step is also unnecessary. It is preferred that after the development and gumming, the excess processing solution is removed using a squeeze roller or the like, followed by drying.

After the developing step, it is preferred to provide a drying step continuously or discontinuously. The drying can be conducted using, for example, hot air, infrared ray or far-infrared ray.

The development processing can be carried out using a conventional processor comprising a pre-heating unit, a pre-water washing unit for removing a protective layer, a development processing unit, a water washing unit and a gum treatment unit. In this case, in the pre-water washing unit washing with water is not conducted and only the roller transportation is used. The development processing unit is connected to an external tank for maintaining the developer level constantly to circulate the developer by a pump. It is preferred to provide a filter for removing insoluble matter generated in the developer in the circulation system.

Water vaporized from the developing bath is replenished from a water replenishing tank to the developing bath utilizing a liquid level meter placed in the external tank.

The water washing unit is used as it is or washing with water is not conducted and only the roller transportation is used therein. In the case of using only for the transportation, it is necessary to wipe the transporting rollers every day because they are contaminated with the developer.

Further, the gum treatment bath may be used as it is by holding a gum solution or a developer therein or gum treatment is not conducted and only the roller transportation is used therein. In the case of using only for the transportation, it is necessary to wipe the transporting rollers every day because they are contaminated with the developer.

### [PS plate]

The constitutions of the PS plate for use in the invention are described in order.

The PS plate according to the invention comprises a support, an undercoat layer, if desired, an image-recording layer and a protective layer. These are described in detail below.

### [Support]

First, the support of the PS plate for use in the invention is described below.

Although any support having a hydrophilic surface may be used, a dimensionally stable plate-like material is preferably used for the support. A support having an aluminum surface is particularly preferably used. An aluminum support is preferably subjected to a graining treatment, an anodizing treatment and further a surface hydrophilizing treatment, for example, with sodium silicate, potassium fluorozirconate or a phosphate. Ordinarily, the thickness of the support is approximately from 0.05 to 1 mm.

Specifically, supports described in Paragraph Nos. [0215] to [0227] of JP-A-2008-256742 are used.

### [Undercoat layer]

On a support (in case of an aluminum support, the aluminum support appropriately subjected to the surface treatment as described above is preferable), for example, an image-recording layer is coated and a protective layer is coated on the image-recording layer to prepare a PS plate. In advance of the coating of image-recording layer, an organic or inorganic undercoat layer may be provided on the support, if desired.

Substances for forming the organic undercoat layer are classified into a water-soluble resin and a water-soluble low molecular weight compound.

The water-soluble resin includes, fro example, a polymer or copolymer having a phosphonic acid group, a phosphoric acid group, a sulfonic acid group, a carboxyl group or salt of such a functional group in its side chain. Specific examples thereof include polyvinylphosphonic and a copolymer thereof, polyacrylic acid or a copolymer thereof, carboxymethyl cellulose, dextrin and gum arabic. A phosphorus compound having ethylenic double bond reactive group described in JP-A-2-304441 is preferably exemplified. As a particularly preferable compound, a compound having a polymerizable group, for example, a methacryl group or an allyl group and a support adsorbing group, for example, a sulfonic acid group, a phosphoric acid group or a phosphoester group is exemplified. A compound having a hydrophilicity-providing group, for example, an ethyleneoxide group in addition to the polymerizable group and the support adsorbing group is also exemplified as a preferable compound.

The low molecular weight organic compound for use in the organic undercoat layer includes, for instance, a phosphonic acid having an amino group, for example, 2-aminoethylphosphonic acid, an organic phosphonic acid, for example, phenylphosphonic acid, naphthylphosphonic acid, alkylphosphonic acid, glycerophosphonic acid, polyvinylphosphonic acid, methylenediphosphonic acid or ethylenediphosphonic acid, each of which may have a substituent, an organic phosphoric acid, for example, phenylphosphoric acid, naphthylphosphoric acid, alkylphosphoric acid or glycerophosphoric acid, each of which may have a substituent, an organic phosphinic acid, for example, phenylphosphinic acid, naphthylphosphinic acid, alkylphosphinic acid or glycerophosphinic acid, each of which may have a substituent, an amino acid, for example, glycine or β-alanine, a hydrochloride of amine having a hydroxy group, for example, triethanolamine hydrochloride and a yellow dye. The organic compounds may be used as a mixture of two or more thereof.

The coverage of the organic undercoat layer is suitably from 2 to 200 mg/m², and preferably from 5 to 100 mg/m². When the coverage of the organic undercoat layer is less than 2 mg/m², sufficient printing durability may not be obtained in some cases. When the coverage thereof is more than 200 mg/m², the same problem may also arise.

Examples of the substance used in the inorganic undercoat layer include an inorganic salt, for example, cobalt acetate, nickel acetate or potassium fluorotitanate. A method of providing the inorganic undercoat layer is similar to that of the organic undercoat layer described above. A sol-gel treatment where a functional group capable of initiating an addition reaction upon a radical is covalently bonded on the surface of support as described in JP-A-7-159983 may be performed.

From the standpoint of increase in printing durability, the undercoat layer preferably contains a polymer or copolymer having any one of a phosphonic acid group, a phosphoric acid group and a sulfonic acid group in its side chain. In case of the copolymer, it contains a polymerization component having such a group preferably from 10 to 90% by mole, and more preferably from 20 to 50% by mole. Further, the copolymer preferably contains an ethylenically unsaturated bond in its side chain. The copolymer contains a polymerization component having the ethylenically unsaturated bond preferably from 10 to 90% by mole, and more preferably from 15 to 40% by mole.

### [Image-recording layer]

The image-recording layer of the lithographic printing plate precursor for use in the invention is preferably a photopolymerization type image-forming layer containing as the essential components, (i) a sensitizing agent, (ii) a polymerization initiator, (iii) an addition polymerizable compound having an ethylenically unsaturated double bond and (iv) a binder polymer.

### [Sensitizing agent]

The sensitizing agent for use in the invention is a dye capable of transmitting the energy of laser beam absorbed to a polymerization initiator with energy transfer or electron transfer.

An absorption wavelength of the sensitizing agent is not particularly restricted as long as the sensitizing agent has the above-described function. The sensitizing agent is appropriately selected depending on a wavelength of laser used for the exposure. In the invention, particularly, a sensitizing agent having an absorption maximum in a wavelength range of 360 to 450 nm or an infrared absorbing agent is preferably used.

Such sensitizing agents include, for example, merocyanine dyes, benzopyrans, coumarins, aromatic ketones and anthracenes.

Specifically, sensitizing agents described in Paragraph Nos. [0134] to [0177] of JP-A-2008-256742 are used.

Since the sensitizing agent has a different extinction coefficient depending on the structure thereof, the amount of the sensitizing agent added is varied according to the structure thereof. The amount thereof is suitably an amount in that absorbance of the image-recording layer at a laser emitting wavelength is 0.6 or less, preferably in a range from 0.05 to 0.55, more preferably in a range from 0.1 to 0.3, and still more preferably in a range form 0.1 to 0.45.

### [Polymerization initiator]

The polymerization initiator for use in the image-recording layer according to the invention is a photopolymerization initiator or thermal polymerization initiator which generates a radical with light energy or heat energy and a compound which initiates or accelerates polymerization of an ethylenically unsaturated compound. The polymerization initiator is appropriately selected to use, for example, from known radical polymerization initiators and compounds containing a bond having small bond dissociation energy.

The polymerization initiators include, for example, organic halogen compounds, carbonyl compounds, organic peroxides, azo compounds, azido compounds, metallocene compounds, hexaarylbiimidazole compounds, organic boron compounds, disulfone compounds, oxime ester compounds and onium salt compounds.

Specifically, polymerization initiators described in Paragraph Nos. [0105] to [0133] of JP-A-2008-256742 are used.

### [Addition polymerizable compound having ethylenically unsaturated double bond]

The addition polymerizable compound having an ethylenically unsaturated double bond for use in the invention can be appropriately selected from compounds having at least one, preferably two or more ethylenically unsaturated double bond groups. The compound has a chemical form, for example, a monomer, a prepolymer, specifically, a dimmer, a trimer or an oligomer, a copolymer thereof or a mixture thereof. Examples of the monomer include an ester between an unsaturated carboxylic acid (for example, acrylic acid, methacrylic acid, itaconic acid, crotonic acid, isocrotonic acid or maleic acid) and an aliphatic polyhydric alcohol compound and an amide between an unsaturated carboxylic acid and an aliphatic polyvalent amine compound.

Specifically, addition polymerizable compounds having an ethylenically unsaturated double bond described in Paragraph Nos. [0074] to [0085] of JP-A-2008-256742 are used.

An amount of the addition polymerizable compound having an ethylenically unsaturated double bond used is preferably in a range of 5 to 90% by weight, more preferably in a range of 20 to 75% by weight, based on the total solid content of the image-recording layer.

### [Binder polymer]

The binder polymer for use in the invention is not particularly restricted and from the standpoint of solubility in an aqueous week alkali solution and developing property, an organic polymer having an acid group is preferable and an organic polymer having a carboxylic acid is more preferable. Examples of such an organic polymer include addition polymers having a carboxylic acid group in their side chains, for example, polymers described in JP-A-59-44615, JP-B-54-34327 (the term "JP-B" as used herein means an "examined Japanese patent publication"), JP-B-58-12577, JP-B-54-25957, JP-A-54-92723, JP-A-59-53836 and JP-A-59-71048, specifically, methacrylic acid copolymers, acrylic acid copolymers, itaconic acid copolymers, crotonic acid copolymers, maleic acid copolymers and partially esterified maleic acid copolymers.

Also, an acidic cellulose derivative having a carboxylic acid group in its side chain and a product obtained by adding a cyclic acid anhydride to an addition polymer having a hydroxy group are exemplified.

Further, polyurethane resins described in JP-B-7-120040, JP-B-7-120041, JP-B-7-120042, JP-B-8-12424, JP-A-63-287944, JP-A-63-287947, JP-A-1-271741 and JP-A-11-352691 are also useful as a binder polymer soluble or swellable in an aqueous weak alkali solution.

As the binder polymer, an acrylic resin, a methacrylic resin or a urethane resin is preferably used.

Into the image-recording layer for use in the invention, other components may be incorporated in addition to the essential components described above, if desired. For instance, the image-recording layer may contain a dye or pigment capable of absorbing light having a wavelength of a laser emission wavelength for use in the image exposure ± 50 nm. However, such a dye or pigment is different from the sensitizing dye and does not have the function for transmitting energy to the polymerization initiator.

The above-described dye or pigment is not particularly restricted as long as it is a dye or pigment which is capable of absorbing light having a wavelength range of a laser emission wavelength ± 50 nm. It is preferably a dye or pigment having an absorption maximum in a wavelength range of a laser emission wavelength ± 50 nm, more preferably a dye or pigment having an absorption maximum in a wavelength range of a laser emission wavelength ± 20 nm, and still more preferably a dye or pigment having an absorption maximum at a wavelength same as a laser emission wavelength.

Examples of the yellow dye include yellow acid dyes. Specific examples of the yellow dye include acid dyes described in Senryo Binran (Dye Handbook) and a group of C.I. Acid Yellow. Particularly preferable examples thereof include C.I. Acid Yellow 17, C.I. Acid Yellow 19, C.I. Acid Yellow 23, C.I. Acid Yellow 38, C.I. Acid Yellow 42, C.I. Acid Yellow 61, C.I. Acid Yellow 72 and C.I. Acid Yellow 141.

An amount of the dye or pigment added to the image-recording layer is preferably 0. 01% by weight or more, more preferably 0.05% by weight or more, based on the weight of the image-recording layer. Also, from the standpoint of maintaining the amount of light reaching the image-recording layer and keeping the sensitivity in a preferable range, the amount of the dye or pigment added is preferably 10% by weight or less, more preferably 5% by weight or less.

To the image-recording layer for use in the invention may be added an additive, for instance, a small amount of a thermal polymerization inhibitor for the purpose of preventing the addition polymerizable compound having an ethylenically unsaturated double bond from undergoing undesirable thermal polymerization during the production or preservation of the composition (photopolymerization type photosensitive composition) for forming the image-recording layer, a higher fatty acid derivative, for example, behenic acid or behenic acid amide for the purpose of avoiding polymerization inhibition due to oxygen, a coloring agent for the purpose of coloring the image-recording layer, or inorganic filler or a plasticizer for the purpose of improving physical properties of the cured layer. An amount of the additive is preferably 10% by weight or less based on the total components of the photopolymerization type photosensitive composition.

To the composition for forming the image-recording layer can be added a surfactant for improving surface quality of the coated layer. Preferable examples of the surfactant include a fluorine-based nonionic surfactant.

According to the invention, the composition for image-recording layer is coated on the support described hereinbefore to form an image-recording layer. In case of coating the composition for image-recording layer on the support, the photosensitive composition is dissolved in an organic solvent to prepare a coating solution. As the solvent capable of being used, specifically, coating solvents described in Paragraph No. [0213] of JP-A-2008-256742 are used.

The solvents may be used individually or as a mixture thereof. The concentration of solid content in the coating solution is appropriately from 1 to 50% by weight.

The coverage of the image-recording layer of the lithographic printing plate precursor according to the invention is preferably in a range of about 0.1 to about 10 g/m², more preferably in a range of 0.3 to 5 g/m², still more preferably in a range of 0.5 to 3 g/m², in terms of weight after coating and drying.

### [Protective layer]

On the image-recording layer, an oxygen blocking protective layer is preferably provided in order to avoid polymerization inhibiting function of oxygen.

The coating amount of the protective layer is preferably in a range of 0.5 to 3.0 g/m². When the coating amount is less than 0.5 g/m², the sensitivity may decrease in some cases, whereas when it exceeds 3.0 g/m², the burden on processing process may increase in some cases. The coating amount is preferably in a range of 0.7 to 2.5 g/m².

In the protective layer, a water-soluble resin, particularly polyvinyl alcohol having good oxygen blocking property, is preferably used. A modified polyvinyl alcohol is also used. Particularly, an acid-modified polyvinyl alcohol is preferable because it can be easily removed by the development processing. Further, for the purpose of increasing the oxygen blocking property and strength of coated layer, a fine inorganic particle, particularly an inorganic stratiform compound, in particular, mica is introduced into the protective layer.

The protective layer preferably contains a water-soluble polymer. The water-soluble polymer specifically includes, for example, polyvinyl alcohol, a partial ester, ether or acetal thereof and a copolymer thereof containing a substantial amount of an unsubstituted vinyl alcohol unit necessary for providing the water-solubility. The polyvinyl alcohol preferably has a hydrolysis degree of 71 to 100% and a polymerization degree of 300 to 2, 400. Specifically, PVA-105, PVA-110, PVA-117, PVA-117H, PVA-120, PVA-124, PVA-124H, PVA-CS, PVA-CST, PVA-HC, PVA-203, PVA-204, PVA-205, PVA-210, PVA-217, PVA-220, PVA-224, PVA-217EE, PVA-217E, PVA-220E, PVA-224E, PVA-405, PVA-420, PVA-613 and L-8, produced by Kuraray Co., Ltd., are exemplified. Further, polyvinyl acetate chloroacetate or propionate, polyvinyl formal and polyvinyl acetal each hydrolyzed to an extent of 88 to less than 100% are exemplified. Other useful water-soluble polymers include, for example, polyvinyl pyrrolidone, gelatin and gum arabic. The water-soluble polymers may be used individually or in combination.

In order to obtain the particularly preferable results according to the invention, it is desired to use polyvinyl alcohol having a hydrolysis degree of 95% or more.

The acid-modified polyvinyl alcohol is not particularly restricted as long as it is a vinyl alcohol polymer containing an appropriate amount of an acid group. Particularly, a vinyl alcohol polymer including appropriate amount of a sulfonic acid group or a carboxyl group is preferably used. The former is referred to as a sulfonic acid-modified polyvinyl alcohol and the latter is referred to as a carboxylic acid-modified polyvinyl alcohol.

The acid-modified polyvinyl alcohol is preferably synthesized by a method wherein a monomer having an acid group is copolymerized with vinyl acetate and then the vinyl acetate is partially or wholly saponified to change to vinyl alcohol. However, it is also possible to synthesize by connecting a compound having an acid group to a hydroxy group of polyvinyl alcohol.

The coverage of the protective layer is preferably in a range of about 0.1 to about 15 g/m², and more preferably in a range of about 1.0 to about 5.0 g/m².

### [Developer]

The developer is a processing solution used in the developing step and is preferably an aqueous solution containing a carbonate ion, a hydrogen carbonate ion and a water-soluble polymer compound, but it is not particularly restricted as long as it does not deteriorate effects of the invention. The presence of carbonate ion and hydrogen carbonate ion generates a buffer function in the developer and prevents fluctuation of pH of the developer even when the developer is used for a long period of time. As a result, the deterioration of developing property resulting from the fluctuation of pH, the occurrence of development scum and the like are restrained. In order for the carbonate ion and hydrogen carbonate ion to be present in the developer, a carbonate and a hydrogen carbonate may be added to the developer or the carbonate ion and hydrogen carbonate ion may be generated by adding a carbonate or a hydrogen carbonate to a developer and then adjusting the pH. The carbonate or hydrogen carbonate used is not particularly restricted and it is preferably an alkali metal salt thereof. Examples of the alkali metal include lithium, sodium and potassium and sodium is particularly preferable. The alkali metals may be used individually or in combination of two or more thereof.

The pH of the developer is not particularly restricted as long as it exhibits the buffer function and it is preferably in a range of 8.5 to 10.8. When the pH is lower than 8.5, the developing property in the non-image area decreases. On the other hand, when the pH is higher than 10.8, the developer is affected by carbon dioxide in the air to degrade the processing ability.

The total amount of the carbonate and hydrogen carbonate is preferably from 1 to 20% by weight, more preferably from 3 to 15% by weight, particularly preferably from 4 to 12% by weight, based on the total weight of the aqueous alkali solution. When the total amount is 1% by weight or more, the developing property and processing ability are not degraded. When the total amount is 20% by weight or less, precipitates and crystals hardly generate and since gelation at neutralization of waste liquid of the developer hardly occur, treatment of the waste liquid can be carried out without trouble.

For the purpose of finely adjusting the alkali concentration or aiding dissolution of the image-recording layer in the non-image area, an alkali agent, for example, an organic alkali agent may be supplementarily used together. Examples of the organic alkali agent include monomethylamine, dimethylamine, trimethylamine, monoethylamine, diethylamine, triethylamine, monoisopropylamine, diisopropylamine, triisopropylamine, n-butylamine, monoethanolamine, diethanolamine, triethanolamine, monoisopropanolamine, diisopropanolamine, ethyleneimine, ethylenediamine, pyridine and tetramethylammonium hydroxide. The supplementary alkali agents may be used individually or in combination of two or more thereof.

The water-soluble polymer compound for use in the invention includes, for example, soybean polysaccharide, modified starch, gum arabic, dextrin, a cellulose derivative (for example, carboxymethyl cellulose, carboxyethyl cellulose or methyl cellulose) or a modified product thereof, pllulan, polyvinyl alcohol or a derivative thereof, polyvinyl pyrrolidone, polyacrylamide, an acrylamide copolymer, a vinyl methyl ether/maleic anhydride copolymer, a vinyl acetate/maleic anhydride copolymer or a styrene/maleic anhydride copolymer is exemplified. An acid value of the water-soluble polymer compound is preferably from 0 to 3.0 meq/g.

As the soybean polysaccharide, those conventionally known can be used. For example, as a commercial product, Soyafive (produced by Fuji Oil Co., Ltd.) is available and various grade products can be used. The soybean polysaccharide preferably used has viscosity in a range of 10 to 100 mPa/sec in a 10% by weight aqueous solution thereof.

As the modified starch, that represented by formula (III) shown below is preferable. As a starch used for production of the modified starch, any starch, for example, of corn, potato, tapioca, rice or wheat can be used. The modification of starch can be performed, for example, by a method wherein starch is decomposed, for example, with an acid or an enzyme to an extent that the number of glucose residue per molecule is from 5 to 30 and then oxypropylene is added thereto in an alkali.

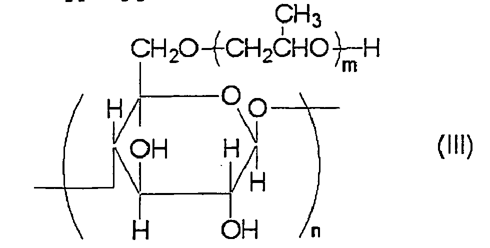

In formula (III), the etherification degree (substitution degree) is in a range of 0.05 to 1.2 per glucose unit, n represents an integer of 3 to 30, and m represents an integer of 1 to 3.

Of the water-soluble polymer compounds, for example, soybean polysaccharide, modified starch, gum arabic, dextrin, carboxymethyl cellulose or polyvinyl alcohol is particularly preferable.

The water-soluble polymer compounds may be used in combination of two or more. The content of the water-soluble polymer compound in the developer is preferably from 0.1 to 20% by weight, and more preferably from 0.5 to 10% by weight.

The developer may contain a surfactant (for example, anionic, nonionic, cationic or amphoteric surfactant).

Examples of the anionic surfactant include fatty acid salts, abietic acid salts, hydroxyalkanesulfonic acid salts, alkanesulfonic acid salts, dialkylsulfosuccinic acid salts, straight-chain alkylbenzenesulfonic acid salts, branched alkylbenzenesulfonic acid salts, alkylnaphthalenesulfonic acid salts, alkylphenoxy polyoxyethylene propylsulfonic acid salts, polyoxyethylene alkylsulfophenyl ether salts, N-methyl-N-oleyltaurine sodium salt, N-alkylsulfosuccinic acid monoamide disodium salts, petroleum sulfonic acid salts, sulfated castor oil, sulfated beef tallow oil, sulfate ester slats of fatty acid alkyl ester, alkyl sulfate ester salts, polyoxyethylene alkyl ether sulfate ester salts, fatty acid monoglyceride sulfate ester salts, polyoxyethylene alkyl phenyl ether sulfate ester salts, polyoxyethylene styryl phenyl ether sulfate ester salts, alkyl phosphate ester salts, polyoxyethylene alkyl ether phosphate ester salts, polyoxyethylene alkyl phenyl ether phosphate ester salts, partially saponified products of styrene-maleic anhydride copolymer, partially saponified products of olefin-maleic anhydride copolymer, naphthalene sulfonate formalin condensates. Of the compounds, dialkylsulfosuccinic acid salts, alkyl sulfate ester salts and alkylnaphthalenesulfonic acid salts are particularly preferably used.

The cationic surfactant is not particularly limited and conventionally known cationic surfactants can be used. Examples of the cationic surfactant include alkylamine salts, quaternary ammonium salts, polyoxyethylene alkyl amine salts and polyethylene polyamine derivatives.

Examples of the nonionic surfactant include polyethylene glycol type higher alcohol ethylene oxide addacts, alkylphenol ethylene oxide addacts, fatty acid ethylene oxide addacts, polyhydric alcohol fatty acid ester ethylene oxide addacts, higher alkylamine ethylene oxide addacts, fatty acid amide ethylene oxide addacts, ethylene oxide addacts of fat, polypropylene glycol ethylene oxide addacts, dimethylsiloxane-ethylene oxide block copolymers, dimethylsiloxane-(propylene oxide-ethylene oxide) block copolymers, fatty acid esters of polyhydric alcohol type glycerol, fatty acid esters of pentaerythritol, fatty acid esters of sorbitol and sorbitan, fatty acid esters of sucrose, alkyl ethers of polyhydric alcohols and fatty acid amides of alkanolamines.

In the invention, ethylene oxide addacts of sorbitol and/or sorbitan fatty acid esters, polypropylene glycol ethylene oxide addacts, dimethylsiloxane-ethylene oxide block copolymers, dimethylsiloxane-(propylene oxide-ethylene oxide) block copolymers and fatty acid esters of polyhydric alcohols are more preferable.

Further, from the standpoint of stable solubility in water or opacity, with respect to the nonionic surfactant, the HLB (hydrophile-lipophile balance) value thereof is preferably 6 or more, and more preferably 8 or more. Furthermore, an oxyethylene adduct of acetylene glycol type or acetylene alcohol type or a surfactant, for example, of fluorine-based or silicon-based can also be used.

The amphoteric surfactant is not particularly limited and includes amine oxide type, for example, alkyldimethylamine oxide, betaine type, for example, alkyl betaine and amino acid type, for example, sodium salt of alkylamino fatty acid.

Particularly, alkyldimethylamine oxide which may have a substituent, alkyl carboxy betaine which may have a substituent and alkyl sulfo betaine which may have a substituent are preferably used. Specifically, compounds described, for example, in Paragraph Nos. [0255] to [0278] of JP-A-2008-203359 and Paragraph Nos. [0028] to [0052] of JP-A-2008-276166 are used.

The surfactants may be used individually or in combination of two or more thereof. The content of the surfactant in the developer is preferably from 0.01 to 10% by weight, and more preferably from 0.01 to 5% by weight.

The developer according to the invention may contain a wetting agent, an antiseptic agent, a chelating agent, a defoaming agent, an organic acid, an organic solvent, an inorganic acid, an inorganic salt or the like in addition the components described above.

As the wetting agent, for example, ethylene glycol, propylene glycol, triethylene glycol, butylene glycol, hexylene glycol, diethylene glycol, dipropylene glycol, glycerin, trimethylol propane or diglycerin is preferably used. The wetting agents may be used individually or in combination of two or more thereof. The wetting agent is ordinarily used in an amount of 0.1 to 5% by weight based on the total weight of the developer.

As the antiseptic agent, for example, phenol or a derivative thereof, formalin, an imidazole derivative, sodium dehydroacetate, a 4-isothiazolin-3-one derivative, benzisotiazolin-3-one, 2-methyl-4-isothiazolin-3-one, a benzotriazole derivative, an amidine guanidine derivative, a quaternary ammonium salt, a pyridine derivative, a quinoline derivative, a guanidine derivative, diazine, a triazole derivative, oxazole, an oxazine derivative or a nitrobromoalcohol-based compound, e.g., 2-bromo-2-nitropropane-1,3-diol, 1,1-dibromo-1-nitro-2-ethanol or 1,1-dibromo-1-nitro-2-propanol is preferably used. It is preferred to use two or more kinds of the antiseptic agents so as to exert the effect to various molds and bacteria. The amount of the antiseptic agent added is an amount stably exerts the effect to bacterium, molds, yeast or the like. Although the amount of the antiseptic agent may be varied depending on the kind of the bacterium, molds, yeast or the like, it is preferably in a range of 0.01 to 4% by weight based on the developer.

As the chelating agent, for example, ethylenediaminetetraacetic acid, potassium salt thereof, sodium salt thereof; diethylenetriaminepentaacetic acid, potassium salt thereof, sodium salt thereof; triethylenetetraminehexaacetic acid, potassium salt thereof, sodium salt thereof; hydroxyethylethylenediaminetriacetic acid, potassium salt thereof, sodium salt thereof; nitrilotriacetic acid, sodium salt thereof; organic phosphonic acids, for example, 1-hydroxyethane-1,1-diphosphonic acid, potassium salt thereof, sodium salt thereof, aminotri(methylenephosphonic acid), potassium salt thereof, sodium salt thereof; and phosphonoalkanetricarboxylic acids are illustrated. A salt of an organic amine is also effectively used in place of the sodium salt or potassium salt in the chelating agent. The chelating agent is so selected that it is stably present in the developer and does not impair the printing property. The amount of the chelating agent added is preferably from 0.001 to 1.0% by weight based on the developer.

As the defoaming agent, for example, a conventional silicone-based self-emulsifying type or emulsifying type defoaming agent, or a nonionic compound having HLB of 5 or less is used. The silicone defoaming agent is preferably used. Any of emulsifying dispersing type and solubilizing type can be used. The content of the defoaming agent is preferably from 0.001 to 1.0% by weight based on the developer.

As the organic acid, for example, citric acid, acetic acid, oxalic acid, malonic acid, salicylic acid, caprylic acid, tartaric acid, malic acid, gluconic acid, lactic acid, levulinic acid, p-toluenesulfonic acid, xylenesulfonic acid, phytic acid and an organic phosphonic acid are illustrated. The organic acid can also be used in the form of an alkali metal salt or an ammonium salt. The content of the organic acid is preferably from 0.01 to 0.5% by weight based on the developer.

As a preferable embodiment of the organic acid, an organic acid which generates, in the developer, a low molecular weight hydroxycarboxylate ion is exemplified. The low molecular weight hydroxycarboxylate ion is an ion of a low molecular weight hydroxycarboxylic acid having a molecular weight of 500 or less. In order for the low molecular weight hydroxycarboxylate ion to be present in the developer, the low molecular weight hydroxycarboxylate ion may be generated by adding a low molecular weight hydroxycarboxylic acid to the developer and then adjusting pH of the developer or by adding a low molecular weight hydroxycarboxylate to the developer. In case of using a low molecular weight hydroxycarboxylic acid having two or more carboxylic acid groups, it is sufficient that at least one of the carboxylic acid groups forms an ion in the developer.

The low molecular weight hydroxycarboxylic acid for forming a low molecular weight hydroxycarboxylate ion specifically includes, for example, gluconic acid, glycolic acid, lactic acid, tartronic acid, a hydroxybutyric acid (for example, 2-hydroxybutyric acid, 3-hydroxybutyric acid or γ-hydroxybutyric acid), malic acid, tartaric acid, citramalic acid, citric acid, isocitric acid, leucic acid, mevalonic acid, pantoic acid, ricinoleic acid, ricinelaidic acid, cerebronic acid, quinic acid, shikimic acid, a monohydroxybenzoic acid (for example, salicylic acid, creosotic acid (also referred to as homosalicylic acid or hydroxyl(methyl)benzoic acid), vanillic acid or syringic acid), a dihydroxybenzoic acid (for example, pyrocatechuic acid, resorcylic acid, protocatechuic acid, gentistic acid or orsellinic acid), a trihydroxybenzoic acid (for example, gallic acid), a phenylacetic acid (for example, mandelic acid, benzilic acid or atrolactic acid), a hydroxycinnamic acid (for example, melilotic acid, phloretic acid, coumaric acid, umbellic acid, caffeic acid, ferulic acid or sinapic acid). Of the compounds, a low molecular weight hydroxycarboxylic acid having two or more carboxylic acid groups is preferable, citric acid, malic acid or tartaric acid is more preferable, and citric acid is most preferable.

A compound having one or more carboxylic acid groups and two or more hydroxy groups is also preferably used as the low molecular weight hydroxycarboxylic acid. Specific examples of such a low molecular weight hydroxycarboxylic acid include gluconic acid, tartaric acid, mevalonic acid, pantoic acid, quinic acid, shikimic acid, a dihydroxybenzoic acid, a trihydroxybenzoic acid, umbellic acid, caffeic acid, dimethylolpropionic acid and carminic acid. Of the compounds, gluconic acid, tartaric acid, mevalonic acid, shikimic acid, gallic acid, dimethylolpropionic acid or carminic acid is preferably used. Further, a low molecular weight hydroxycarboxylic acid having four or more hydroxy groups is also preferably used. Specific examples of such a low molecular weight hydroxycarboxylic acid preferably include gluconic acid and carminic acid.

The low molecular weight hydroxycarboxylate is not particularly restricted and it is preferably an alkali metal salt. Examples of the alkali metal include lithium, sodium and potassium and sodium is particularly preferable. The alkali metals may be used individually or in combination of two or more thereof.

The amount of the low molecular weight hydroxycarboxylate ion is preferably from 0.05 to 5 mole/l, more preferably from 0.2 to 2 mole/l, most preferably from 0.25 to 0.75 mole/l, in the developer. When the amount thereof is 0.05 mole/l or more, a sufficient effect for preventing fingerprint stain is obtained, whereas when the amount thereof is 5 mole/l or less, precipitates and crystals hardly generate and since gelation at neutralization of waste liquid of the developer hardly occurs, the waste liquid treatment can be carried out without trouble.

As the organic solvent, for example, an aliphatic hydrocarbon (e.g., hexane, heptane, Isopar E, Isopar H, Isopar G (produced by Esso Chemical Co., Ltd.), gasoline or kerosene), an aromatic hydrocarbon (e.g., toluene or xylene), a halogenated hydrocarbon (methylene dichloride, ethylene dichloride, trichlene or monochlorobenzene) or a polar solvent is exemplified.

Examples of the polar solvent include an alcohol (e.g., methanol, ethanol, propanol, isopropanol, benzyl alcohol, ethylene glycol monomethyl ether, 2-ethyoxyethanol, diethylene glycol monoethyl ether, diethylene glycol monohexyl ether, triethylene glycol monomethyl ether, propylene glycol monoethyl ether, propylene glycol monomethyl ether, polyethylene glycol monomethyl ether, polypropylene glycol, tetraethylene glycol, ethylene glycol monobutyl ether, ethylene glycol monobenzyl ether, ethylene glycol monophenyl ether, methyl phenyl carbinol, n-amyl alcohol or methylamyl alcohol), a ketone (e.g., acetone, methyl ethyl ketone, ethyl butyl ketone, methyl isobutyl ketone or cyclohexanone), an ester (e.g., ethyl acetate, propyl acetate, butyl acetate, amyl acetate, benzyl acetate, methyl lactate, butyl lactate, ethylene glycol monobutyl acetate, polyethylene glycol monomethyl ether acetate, diethylene glycol acetate, diethyl phthalate or butyl levulinate) and others (e.g., triethyl phosphate, tricresyl phosphate, N-phenylethanolamine or N-phenyldiethanolamine).

Further, when the organic solvent is insoluble in water, it may be employed by being solubilized in water using a surfactant or the like. In the case where the developer contains the organic solvent, the concentration of the organic solvent is desirably less than 40% by weight in view of safety and inflammability.

As the inorganic acid or inorganic salt, for example, phosphoric acid, methaphosphoric acid, ammonium primary phosphate, ammonium secondary phosphate, sodium primary phosphate, sodium secondary phosphate, potassium primary phosphate, potassium secondary phosphate, sodium tripolyphosphate, potassium pyrophosphate, sodium hexamethaphosphate, magnesium nitrate, sodium nitrate, potassium nitrate, ammonium nitrate, sodium sulfate, potassium sulfate, ammonium sulfate, sodium sulfite, ammonium sulfite, sodium hydrogen sulfate or nickel sulfate is illustrated. The amount of the inorganic acid or inorganic salt added is preferably from 0.01 to 0.5% by weight based on the total weight of the developer.

Temperature at the development is ordinarily 60°C or lower, and preferably from about 15 to about 40°C. In the case of conducting the development processing using an automatic developing apparatus, the developer becomes fatigued in accordance with the processing amount, and hence the processing ability may be restored using a replenisher or a fresh developer.

In the processing method of PS plate according to the invention, the entire surface of the PS plate may be heated between the exposure and the development. By the heating, the image-forming reaction in the image-recording layer is accelerated and advantages, for example, improvement in the sensitivity and printing durability and stabilization of the sensitivity may be achieved.

The conditions of the heating can be appropriately determined in a range for providing such effects. Examples of the heating means include a conventional convection oven, an IR irradiation apparatus, an IR laser, a microwave apparatus or a Wisconsin oven. For instance, the heat treatment can be conducted by maintaining the PS plate at a plate surface temperature ranging from 70 to 150°C for a period of one second to 5 minutes, preferably at 80 to 140°C for 5 seconds to one minute, more preferably at 90 to 130°C for 10 to 30 seconds. In the range described above, the effects described above are efficiently achieved and an adverse affect, for example, change in shape of the PS plate due to the heat can be preferably avoided.

It is preferable that heat treatment means used in the heat treatment step is connected with a plate setter used in the exposure step and a developing apparatus used in the development processing step and the PS plate is subjected to automatically continuous processing. Specifically, a plate making line wherein the plate setter and the developing apparatus are connected with each other by transport means, for example, a conveyer is illustrated. Also, the heat treatment means may be placed between the plate setter and the developing apparatus or the heat treatment means and the developing apparatus may constitute a unit apparatus.

In case where the PS plate used is apt to be influenced by surrounding light under a working environment, it is preferable that the plate making line is blinded by a filter, a cover or the like.

The entire surface of lithographic printing plate after development may be exposed to active ray, for example, ultraviolet light to accelerate curing of the image area. As a light source for the entire surface exposure, for example, a carbon arc lamp, a mercury lamp, a gallium lamp, a metal halide lamp, a xenon lamp, a tungsten lamp or various laser beams is exemplified. In order to obtain sufficient printing durability, the amount of the entire surface exposure is preferably 10 mJ/cm² or more, and more preferably 100 mJ/cm² or more. Heating may be performed at the same time with the entire surface exposure. By performing the heating, further improvement in the printing durability is recognized. Examples of the heating means include a conventional convection oven, an IR irradiation apparatus, an IR laser, a microwave apparatus or a Wisconsin oven. The plate surface temperature at the heating is preferably from 30 to 150°C, more preferably from 35 to 130°C, and still more preferably from 40 to 120°C. Specifically, a method described in JP-A-2000-89478 can be used.

Further, for the purpose of increasing printing durability, the lithographic printing plate after development can be heated under very strong conditions. The heat temperature is ordinarily in a range of 200 to 500°C. When the temperature is too low, a sufficient effect of strengthening the image may not be obtained, whereas when it is excessively high, problems of deterioration of the support and thermal decomposition of the image area may occur sometimes.

The lithographic printing plate thus-obtained is mounted on an off-set printing machine to use for printing a large number of sheets.

### EXAMPLES

The present invention will be described in more detail with reference to the following examples, but the invention should not be construed as being limited thereto.

### EXAMPLES 1 TO 3 AND COMPARATIVE EXAMPLE 1

### [Support]

### (a) Alkali etching treatment

Alkali etching treatment of an aluminum plate was conducted by spraying an aqueous solution having sodium hydroxide concentration of 2.6% by weight, aluminum ion concentration of 6.5% by weight and temperature of 70°C to dissolve the aluminum plate in an amount of 10 g/m², followed by washing with water by spraying.

### (b) Desmut treatment

Desmut treatment of the aluminum plate was conducted by spraying an aqueous 1% by weight nitric acid solution (containing 0.5% by weight of aluminum ion) having temperature of 30°C, followed by washing with water by spraying. As the aqueous nitric acid solution for the desmut treatment, a waste liquid from a process of electrochemical surface roughening treatment using alternating current in an aqueous nitric acid solution was used.

### (c) Electrochemical surface roughening treatment

Electrochemical surface roughening treatment of the aluminum plate was continuously conducted by applying 60 Hz alternating current voltage. The electrolytic solution used was an aqueous solution containing 10.5 g/liter of nitric acid (containing 5 g/liter of aluminum ion and 0.007% by weight of ammonium ion) and the solution temperature was 50°C. The electrochemical surface roughening treatment was conducted using a trapezoidal rectangular wave alternating current where time (TP) for reaching the current to its peak from zero was 0.8 msec and a duty ratio was 1:1, and using a carbon electrode as a counter electrode. A ferrite was used as an auxiliary anode. The electrolytic cell used was a radial cell type. The current density was 30 A/dm² at the peak current, and the electric quantity was 220 C/dm² in terms of the total electric quantity during the aluminum plate functioning as an anode. To the auxiliary anode, 5% of the current from the electric source was divided. Subsequently, the plate was washed with water by spraying.

### (d) Alkali etching treatment

Alkali etching treatment of the aluminum plate was conducted at 32°C by spraying an aqueous solution having a sodium hydroxide concentration of 26% by weight and an aluminum ion concentration of 6.5% by weight to dissolve the aluminum plate in an amount of 0.50 g/m². Thus, the smut component mainly comprising aluminum hydroxide formed in the precedent step of electrochemical surface roughening treatment using alternating current was removed and an edge portion of the pit formed was dissolved to smoothen the edge portion. Subsequently, the plate was washed with water by spraying.

### (e) Desmut treatment

Desmut treatment of the aluminum plate was conducted by spraying an aqueous nitric acid solution having temperature of 30°C, followed by washing with water by spraying. As the aqueous nitric acid solution for the desmut treatment, a waste liquid from a process of electrochemical surface roughening treatment using alternating current in an aqueous nitric acid solution was used.

### (f) Anodizing treatment

Anodizing treatment of the aluminum plate was conducted using an anodizing treatment apparatus according to a two-stage feeding electrolytic treatment method (lengths of a first electrolytic unit and a second electrolytic unit: 6 m each; lengths of a first feeding unit and a second feeding unit: 3 m each; lengths of a first feeding electrode unit and a second feeding electrode unit: 2.4 m each). The electrolytic solution supplied to the first electrolytic unit and second electrolytic unit was an aqueous solution having sulfuric acid concentration of 50 g/liter (containing 0.5% by weight of aluminum ion) and the solution temperature was 20°C. Subsequently, the plate was washed with water by spraying. The amount of the final anodic oxide film was 2.7 g/m².

### (g) Treatment with polyvinylphosphonic acid

The aluminum plate was treated with an aqueous solution containing 4 g/liter of polyvinylphosphonic acid at 40°C for 10 seconds, washed with demineralized water at 20°C for 2 seconds and dried.

### [Image-recording layer and Protective layer]

A coating solution for image-recording layer having the composition shown below was coated on the support using a bar and dried by an oven at 100°C for 44 seconds to form an image-recording layer having a dry coating amount of 1.3 g/m². A coating solution for protective layer having the composition shown below was coated on the image-recording layer using a bar and dried by an oven at 125°C for 70 seconds to form a protective layer having a dry coating amount of 1.25 g/m², thereby preparing a PS plate.

### <Coating solution for image-recording layer>

| | | |
|---|---|---|
| Binder Polymer PU-A shown below | | 0.45 g |
| Polymerizable Compound (1) | | 0.52 g |
| | (PLEX 6661-O, produced by Degussa Japan) | |
| Sensitizing Dye (1) shown below | | 0.04 g |
| Polymerization Initiator (1) shown below | | 0.08 g |
| Co-Sensitizer (1) shown below | | 0.05 g |
| Dispersion of ε-phthalocyanine pigment | | 0.40 g |
| | [pigment: 15 parts by weight; dispersing agent (Polymer (1) shown below): 10 parts by weight; solvent (cyclohexanone/methoxypropyl acetate/1-methoxy-2-propanol = 15 parts by weight/20 parts by weight/40 parts by weight)] | |
| Thermal polymerization inhibitor | | 0.006 g |
| | (N-nitrosophenylhydroxylamine aluminum salt) | |
| Fluorine-Based Surfactant (1) shown below | | 0.002 g |
| 1-Methoxy-2-propanol | | 8.0 g |
| Methyl ethyl ketone | | 8.0 g |

### Binder Polymer PU-A:

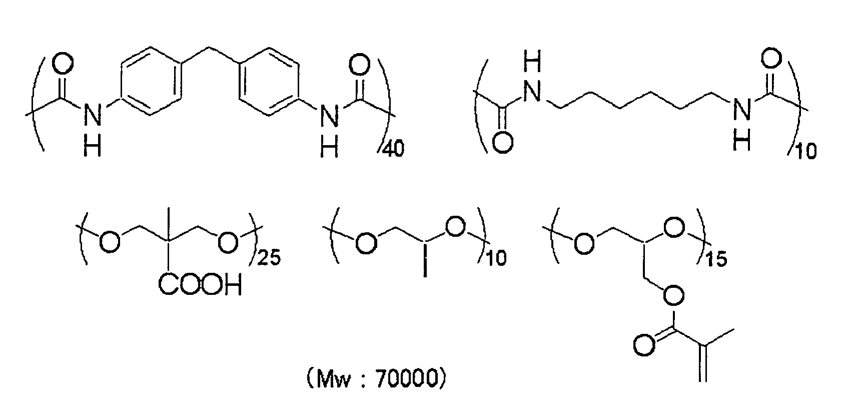

### Polymerizable Compound (1):

A mixture of the following isomers:

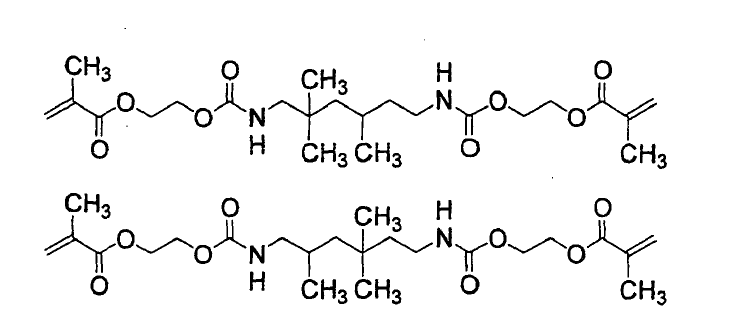

### Polymer (1):

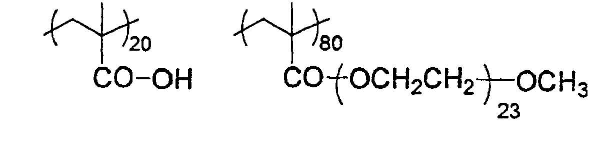

### Sensitizing Dye (1):

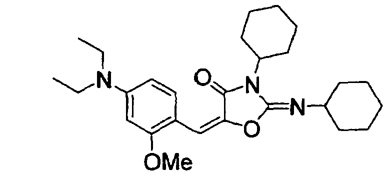

### Polymerization Initiator (1):

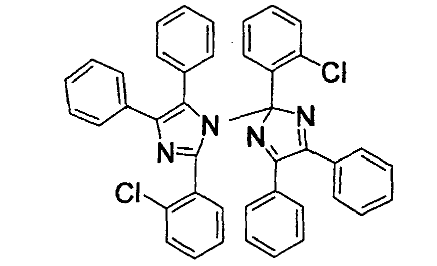

### Co-Sensitizer (1):

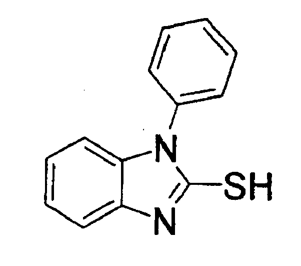

### Fluorine-Based Surfactant (1):

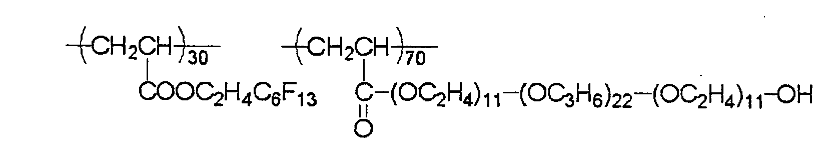

### <Coating solution for protective layer>

| | |
|---|---|
| Dispersion of mica shown below | 0.6 g |
| Sulfonic acid-modified polyvinyl alcohol [Goseran CKS-50, produced by Nippon Synthetic Chemical Industry Co., Ltd. (saponification degree: 99% by mole; average polymerization degree: 300; modification degree: about 0.4% by mole)] | 0.8 g |
| Vinyl pyrrolidone/vinyl acetate (1/1) copolymer (molecular weight: 70,000) | 0.001 g |
| Surfactant (Emalex 710, produced by Nihon Emulsion Co., Ltd.) | 0.002 g |
| Water | 13 g |

### (Preparation of Dispersion of mica)

In 368 g of water was added 32 g of synthetic mica (SOMASIF ME-100, produced by CO-OP Chemical Co., Ltd.; aspect ratio: 1,000 or more) and the mixture was dispersed using a homogenizer until the average particle diameter (measured by a laser scattering method) became 0.5 µm to obtain Dispersion of mica.

### <Developer>

A developer (pH: 9.8) having the composition shown below was prepared. The amount of the component of developer is indicated in grams.

| | |
|---|---|
| Softazoline LPB-R having chemical formula shown below (produced by Kawaken Fine Chemicals Co, Ltd.) (30% aqueous solution) | 150 g |
| Softazoline LAO having chemical formula shown below (produced by Kawaken Fine Chemicals Co, Ltd.) (30% aqueous solution) | 40 g |
| Chelating agent: Octaquest E30 (produced by Innospec Specialty Chemicals Ltd.) (trisodium ethylenediaminesuccinate) | 6.8 g |
| 2-Bromo-2-nitropropane-1,3-diol | 0.25 g |
| 2-Methyl-4-isothiazolin-3-one | 0.25 g |
| Silicone-based defoaming agent (TSA 739, produced by GE Toshiba Silicones Co., Ltd.) | 1.5 g |
| Sodium gluconate | 15 g |
| Sodium carbonate | 10.6 g |
| Sodium hydrogen carbonate | 5.2 g |
| Water | 770.4 g |
| pH | 9.8 |

### Softazoline LPB-R:

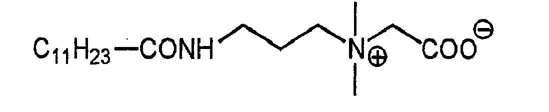

### Softazoline LAO:

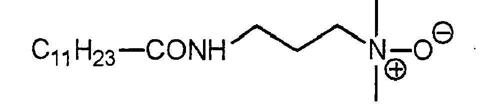

### <Automatic developing apparatus>

The development processing was conducted by an automatic developing apparatus having structure shown in Fig. 1. The automatic developing apparatus had two rotating brush rollers each having an outer diameter of 54 mm and being implanted with fiber of nylon 6. 12 (bristle diameter: 75 µm, bristle length: 8.5 mm) . The first brush roller was rotated at 150 rpm in the opposite direction to the transporting direction. The second brush roller rotated at 150 rpm in the same direction as the transporting direction. The PS plate was developed at transporting speed of 160 cm/min for 19 seconds. The temperature of development was 28°C. The pre-heating was conducted at a plate surface temperature of 100°C for 15 seconds.

The capacity of the developing tank was set to 83 liters and the capacity of the external tank was set to 17 liters so that the total volume of the developer was 100 liters. The capacity of pump for liquid circulation between the external tank and the developing tank was set to 300 ml per minute. In the liquid circulation between the external tank and the developing tank, two spool-shaped filters of Micro-Wynd made of polypropylene, CUNO filter produced by 3M Co. were disposed. The first filter had filtration accuracy of 100 µm and the second filter had filtration accuracy of 10 µm.

As for the replenishment of water to the developing tank, water decreased by vaporization was replenished with ion-exchanged water. As the water softening apparatus, Softener D'acqua M (trade name in Japan) produced by Inoxdep (agency: Komichi-Shobo Publishers) which was a water softening apparatus of ion exchange resin type was used.

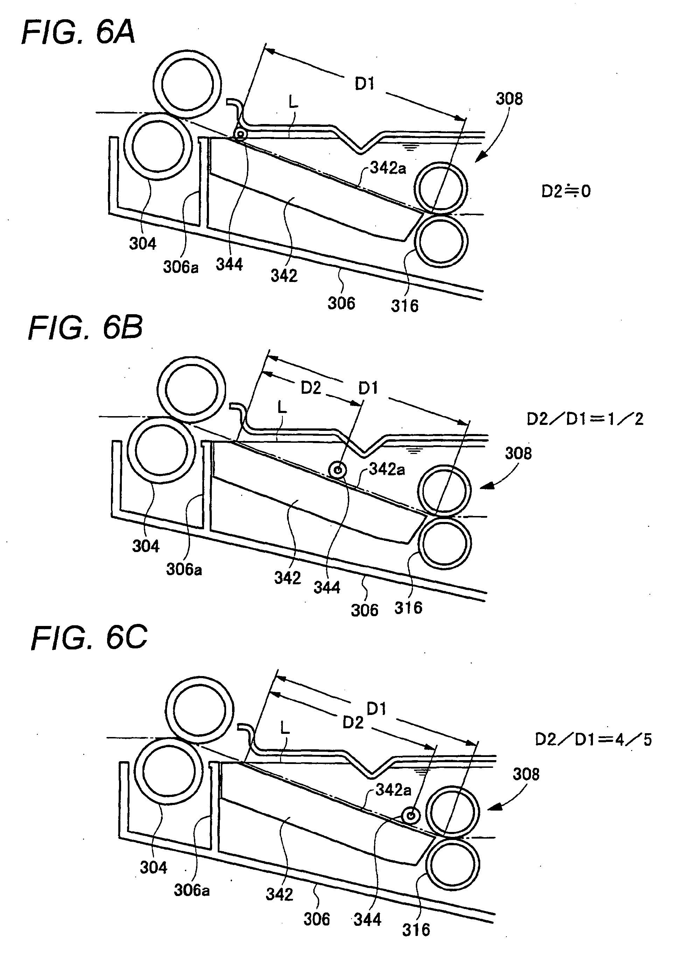

The guide roller was deposited at a deferent position with each of the examples. Figs. 6A, 6B and 6C are views showing the position of guide roller in each example. In Figs. 6A, 6B and 6C, a distance from an intersection point of liquid level L of the developer with a transporting pass 11 of the PS plate to a point where the transporting pass 11 comes into contact with the submerged roller 316 is taken as D1 and a distance from the intersection point to a point where the transporting pass 11 comes into contact with the guide roller 344 is taken as D2. In Example 1 (Fig. 6A), the guide roller 344 was disposed at almost same position as the liquid level L, that is, D2 is nearly 0. In Example 2 (Fig. 6B), the guide roller 344 was disposed at the position where D2/D1 is 1/2 (=0.5). In Example 3 (Fig. 6C), the guide roller 344 was disposed at the position where D2/D1 is 4/5 (= 0.8).

The development processing was performed under the respective conditions using 3,000 sheets of PS plates having a length of 1,030 mm, a width of 800 mm and a thickness of 0.3 mm.

### [Exposure]

The PS plate was subjected to image exposure by Violet Semiconductor Laser Plate Setter Vx9600 (equipped with InGaN semiconductor laser; emission: 405 nm ± 10 nm/output: 30 mW) produced by FFEI, Ltd. The image was drawn using an FM screen (TAFFETA 20, produced by Fuji Film Co., Ltd.) in a plate surface exposure amount of 0.05 mJ/cm² and at resolution of 2,438 dpi.

### [Evaluation]

Wetness of the insertion roller in the developing unit and image unevenness and presence or absence of remaining layer on a printing plate were evaluated using the PS plate.

After the development processing of 3, 000 sheets of the PS plates, the occurrence of wetness of the insertion roller in the developing unit of automatic developing apparatus was visually observed. As for the evaluation of image unevenness, image unevenness on a printing plate obtained by exposure of the PS plate with halftone dots of FM screen (TAFFETA 20, produced by Fuji Film Co., Ltd.) having high precision image and development processing was visually observed. Also, the presence or absence of remaining layer on the printing plate was evaluated. A case where the occurrence of wetness of the insertion roller due to the adhesion of developer was not observed was evaluated as "absence". A case where the occurrence of wetness of the insertion roller due to the adhesion of developer was observed was evaluated as "presence". A case where the occurrence of image unevenness was not observed even in the high precision image was evaluated as "A" particularly preferable. A case where the occurrence of image unevenness was in a level causing no problem was evaluated as "B". A case where the occurrence of image unevenness was clearly observed was evaluated as "C". A case where the presence of remaining layer was not observed was evaluated as "absence". A case where the presence of remaining layer was observed was evaluated as "presence". The results of Examples 1 to 3 and Comparative Example 1 are shown in Table 1.

**[Table 1]**

| | Position of Guide Roller | Wetness of Insertion Roller | Image Unevenness | Remaining Layer |
|---|---|---|---|---|
| Example 1 | D2 = nearly 0 | Absence | B | Absence |
| Example 2 | D2/D1 = 1/2 | Absence | A | Absence |
| Example 3 | D2/D1 = 4/5 | Absence | B | Absence |
| Comparative Example 1 | No Guide Roller | Presence | B | Presence |

When the guide roller was not disposed as in Comparative Example 1, the wetness of the insertion roller due to the adhesion of developer occurred.

On the contrary, when the guide roller was disposed as in Examples 1 to 3, the occurrence of wetness of the insertion roller was not observed.

Also, in each of Examples 1 to 3 and Comparative Example 1, the occurrence of image unevenness could be kept within the acceptable level to obtain the good image. Particularly, in Example 2, the occurrence of image unevenness could be remarkably inhibited to obtain high image quality suitable for the high precision image.

Further, in each of Examples 1 to 3, the remaining layer on the printing plate did not occur to obtain good result. On the contrary, in Comparative Example 1, the occurrence of remaining layer on the printing plate was recognized.

## Claims

1. An automatic developing apparatus for a lithographic printing plate precursor in which a lithographic printing plate precursor comprising in the following order a support, an image-recording layer and a protective layer is immersed in a developer in a development processing bath after image exposure and heating of the lithographic printing plate precursor to remove the image-recording layer in a non-image area and the protective layer at the same time,
wherein the automatic developing apparatus comprises an insertion roller for introducing the lithographic printing plate precursor into the developing processing bath, a submerged roller disposed in the developer and a guide roller which is arranged between the insertion roller and the submerged roller in the developer and supports the lithographic printing plate precursor transported.

2. The automatic developing apparatus as claimed in claim 1, which further comprises a guide member provided in the developer, the guide member having a surface facing the guide roller and capable of supporting the lithographic printing plate precursor.

3. The automatic developing apparatus as claimed in claim 1 or 2, wherein the guide roller is disposed so that D2/D1 satisfies from 0.25 to 0.75, wherein D1 represents a distance from an intersection point of liquid level of the developer in the development processing bath with a transporting pass of the lithographic printing plate precursor to a point where the transporting pass comes into contact with the submerged roller and D2 represents a distance from the intersection point to a point where the transporting pass comes into contact with the guide roller.

4. The automatic developing apparatus as claimed in any one of claims 1 to 3, wherein the guide roller comprises a shaft member capable of passing the developer through an inside thereof and plural roller members arranged at intervals in a shaft direction of the shaft member and the shaft member has an aperture for ejecting the developer.

5. The automatic developing apparatus as claimed in any one of claims 1 to 4, which further comprises a spatter-preventing member disposed between the insertion roller and the development processing bath so as to project from an edge of the development processing bath to a vicinity of the transporting pass.

6. The automatic developing apparatus as claimed in any one of claims 1 to 5, which further comprises a heating unit for heating the lithographic printing plate precursor after the image exposure at 80 to 140°C.

7. A processing method of a lithographic printing plate precursor in which a lithographic printing plate precursor comprising in the following order a support, an image-recording layer and a protective layer is immersed in a developer in a development processing bath after image exposure and heating of the lithographic printing plate precursor to remove the image-recording layer in a non-image area and the protective layer at the same time,
wherein the processing method comprises: introducing the lithographic printing plate precursor into the development processing bath by an insertion roller; and transporting the lithographic printing plate precursor in the developer through a submerged roller disposed in the developer while supporting the lithographic printing plate precursor transported with a guide roller arranged between the insertion roller and the submerged roller.

8. The processing method of a lithographic printing plate precursor as claimed in claim 7, wherein a guide member is provided in the developer, and the lithographic printing plate precursor transported is supported with a surface of the guide member facing the guide roller.

9. The processing method of a lithographic printing plate precursor as claimed in claim 7 or 8, wherein the lithographic printing plate precursor transported is supported by the guide roller, which is disposed so that D2/D1 satisfies from 0.25 to 0.75, wherein D1 represents a distance from an intersection point of liquid level of the developer in the development processing bath with a transporting pass of the lithographic printing plate precursor to a point where the transporting pass comes into contact with the submerged roller and D2 represents a distance from the intersection point to a point where the transporting pass comes into contact with the guide roller.

10. The processing method of a lithographic printing plate precursor as claimed in any one of claims 7 to 9, wherein the lithographic printing plate precursor is processed with the developer containing at least one of a surfactant and a water-soluble polymer compound.

11. The processing method of a lithographic printing plate precursor as claimed in any one of claims 7 to 10, wherein the lithographic printing plate precursor is processed with the developer which has pH of 8.5 to 10.8.

12. The processing method of a lithographic printing plate precursor as claimed in any one of claims 7 to 11, wherein the lithographic printing plate precursor is processed with the developer which contains a carbonate ion and a hydrogen carbonate ion.

13. The processing method of a lithographic printing plate precursor as claimed in any one of claims 7 to 12, wherein the lithographic printing plate precursor is processed with the developer which contains a low molecular weight hydroxycarboxylate ion.

14. The processing method of a lithographic printing plate precursor as claimed in any one of claims 7 to 13, wherein the removal of the non-image area of the image-recording layer and the protective layer and an oil-desensitizing treatment are performed at the same time.

15. The processing method of a lithographic printing plate precursor as claimed in any one of claims 7 to 14, wherein the image-recording layer has a photopolymerizable property.
